# EUROPEAN PATENT SPECIFICATION

(11) **EP 1 853 972 B1**
(45) Date of publication and mention of the grant of the patent: **20.07.2011**
(21) Application number: 06735544.6
(22) Date of filing: 21.02.2006
(51) Int. Cl.: G03F 7/004

(54) **NORBORNENE-TYPE POLYMERS AND THEIR MANUFACTURE PROCESS**
NORBORNENPOLYMERE UND DEREN HERSTELLUNGSVERFAHREN
POLYMERES DE TYPE NORBORNENE ET LEUR PROCEDE DE FABRICATION

(30) Priority: 22.02.2005 US 655176 P; 23.02.2005 US 655351 P; 25.02.2005 US 655901 P; 07.06.2005 US 687871 P; 21.10.2005 US 728756 P; 21.10.2005 US 729091 P
(43) Date of publication of application: 14.11.2007
(60) Divisional application: 08019326.1
(73) Proprietor: Promerus LLC, Brecksville, OH 44141 (US); TOKYO OHKA KOGYO CO., LTD., Kawasaki-shi, Kanagawa 211-0012 (JP)
(72) Inventor: RHODES, Larry, F., Silver Lake, Ohio 44224 (US); CHANG, Chun, Stow, Ohio 44224 (US); KANDANARACHCHI, Pramod, Brecksville, Ohio 44141 (US); SEGER, Lawrence, D., Gates Mills, Ohio 44040 (US); ISHIDUKA, Keita, Tokyo Ohka Kogyo Co., Ltd., Kawasaki-shi, Kanagawa 211-0012 (JP); ENDO, Kotaro, Tokyo Ohka Kogyo Co., Ltd., Kawasaki-shi, Kanagawa 211-0012 (JP); ANDO, Tomoyuki, Tokyo Ohka Kogyo Co., Ltd., Kawasaki-shi, Kanagawa 211-0012 (JP)
(74) Representative: von Kreisler Selting Werner
(86) International application number: PCT/US2006/005928
(87) International publication number: WO 2006/091523

(56) References cited:
- EP-A- 1 376 232
- EP-A- 1 415 974
- EP-A- 1 505 439
- WO-A-2004/076495
- US-B1- 6 420 503
- US-B1- 6 420 503

## Description

### TECHNICAL FIELD

The present invention relates to a non-self imageable polymer consisting of norbornene-type repeating units, a methods of making such a polymer.

### BACKGROUND

In the past, methods for achieving smaller feature sizes have been to select a lithographic radiation source having a shorter wavelength, increase the numerical aperture (NA) of the lithographic system's lens or a combination thereof. While these methods have met with success, for each reduction in wavelength and/or increase in NA, the problems associated with taking advantage of such changes have been increasingly difficult to overcome.

Recently it has been suggested that rather than selecting a new lithographic radiation source with a shorter wavelength, e.g. 157 nm, the resolution of the current 193 nm standard source could be extended by the use of an immersion lithographic process. Such immersion lithographic processes replace the usual "air gap" between a lithographic tool's final lens and the substrate being exposed with a fluid such as, for example, water. The water, having a refractive index that is much greater than that of air, allows for the use of a lens having a NA higher than 1 without the reduction in depth of focus (DOF) that would otherwise result. Thus, it is believed that minimum feature sizes of 45 nm or less can be achieved with such an approach.

However, the successful implementation of immersion lithography for microelectronic device fabrication presents new problems that need to be resolved. For example, typically the substrate being exposed during a microlithographic process is repeatedly repositioned with respect to the lithographic tools lens to achieve complete exposure of all portions of the substrate. The presence of an immersion fluid (also referred to herein as an "immersion medium" or "IM") raises the concern that fluid residues will result from this movement and that such residues will result in an increase in defectivity that would make such a process unacceptable. Also with regard to fluid residue, or residuals, it must be considered that any proposed solution to this problem should not result in a significant decrease in the speed with which such movement is currently accomplished, as such a decrease in movement speed (scanability) could result in an unacceptable decrease in the number of substrates per hour that a lithographic tool can fully expose.

In addition to problems relating to IM residuals and scanability, the use of an IM also raises concerns with regard to problems that can result from such a fluid being in direct contact with the photoresist layer that can lead to a reduction in that layers resolution ability. For example, such problems can include, among others: 1) leaching of small molecules such as photoacid generators (PAGs) and PAG photoproducts from the photoresist film into the IM and 2) absorption of the immersion medium, or components thereof, into the photoresist film.

One method that has been investigated for the elimination or reduction of these and other problems associated with immersion lithography is the use of an intervening layer disposed overlying the photoresist film. Such an intervening layer, also referred to as a "top-coat" or "protecting layer," is thus positioned to receive the immersion material and thus prevent or greatly reduce any effects related to previously mentioned technical problems 1 and 2. With regard to scanability, the use of a top-coat allows for the design of a material having specific properties that will eliminate or greatly reduce the possibility of IM residuals with little or no reduction in the speed of a tool's speed of movement.

Recently, some materials encompassing fluorine-containing polymer(s) have been proposed for use as a top-coat layer. While such materials have been shown to have a positive effect with regards to the problems discussed above, they require the use of a solvent for their removal. As any top-coat layer must be removed to allow for the development of an image in the underlying photoresist layer, a material that requires that a special solvent be used for its removal is problematic in that such removal is an extra step that adds undesirable equipment and material costs as well as costs associated with the reduced productivity such an extra step will necessarily cause.

USBI-6 420 503, WO 2004/076495 and EP-A-1 505 439 disclose polymers containing norbornene repeating units.

Therefore, it would be desirable to provide solutions that can be readily implemented, such solutions directed to the above-related technical problems that may occur with immersion lithography. Such solutions should provide for the reduction or prevention of the leaching of small molecules from a photoresist layer into an immersion medium as well as reduce or prevent the absorption of such immersion medium into such a layer. Such solutions should also serve to reduce defectivity from a level observed when immersion lithography is preformed without such solutions being employed. Further, it would be desirable for such solutions to be cost effective and not require significant alternative process such as observed with the aforementioned solvent removable top-coat material or any significant reduction in scanability when employed.

### BRIEF DESCRIPTION OF THE DRAWINGS

Fig. 1 is a representation of an immersion lithographic system depicting a lens element, having movement in the direction of the arrow, a resist layer and both a fluid (immersion medium) between the resist layer and the lens element as well as non-retained immersion fluid overlying portions of the resist layer; and

Fig. 2 identifies the contact angle, sliding angle and receding angle with respect to a droplet overlying a surface.

### DETAILED DESCRIPTION

The present invention is directed to solving the aforementioned technical problems of immersion lithography. The invention relates to a non-imageable polymer as claimed in claim 1 and to the method of making it as claimed in claim 13. Embodiments thereof are defined in the corresponding dependant claims. Such a polymer provides for the reduction or elimination of the leaching of small molecules from an imaging layer or film into an immersion medium, the absorption of such medium, or components of such medium into the imaging layer, the reduction or elimination of defectivity resulting from any non-retained immersion fluid being formed during the exposure of such imaging layer over the entirety of a substrate without significantly affecting scanability. Where such embodiments encompass a top-coat or non-imageable layer, providing such a layer that is soluble in aqueous base solutions, thus eliminating the need for a distinct top-coat removal step that employs a solvent.

The polymeric materials of the present invention encompass polycyclic repeating units. Such polycyclic repeating units, when referred to as "norbornene-type," are units that are derived from a substituted or unsubstituted norbornene-type monomer, as shown below, where X is -CH₂-, -CH₂CH₂-, O or S and n is an integer from 0 to 5 inclusive:

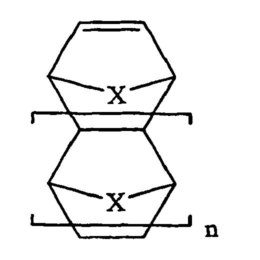

The term "non-self imageable polymer" refers to a polymer (also referred to as a resin) that, when formed into a film or layer having an essentially uniform thickness over a substrate, is not imageable by direct irradiation, for example irradiation by a 193 nanometer (nm) or 157 nm radiation source.

The terms "top-coat material" or 'top-coat composition" are used interchangeably herein and refer to a material or composition that encompasses a non-self imageable polymer. Such composition being useful for forming a protective film over a photoresist layer to protect such photoresist layer during an immersion lithographic process. The protective film (or top-coat layer) is a non-self imageable film.

The term "imageable polymer" refers to a polymer that, when formed into a film or layer having an essentially uniform thickness over a substrate, is imageable by and through direct irradiation, for example irradiation by a 193 nm or 157 nm radiation source.

The terms "imageable material," "imageable composition" or "photoresist material" are used interchangeably herein and refer to a material or composition that encompasses an imageable polymer. Such compositions being useful in the forming of an imaging layer (or photoresist layer) that can be patterned. Photoresist materials of the present invention are useful for immersion and non-immersion lithographic processes.

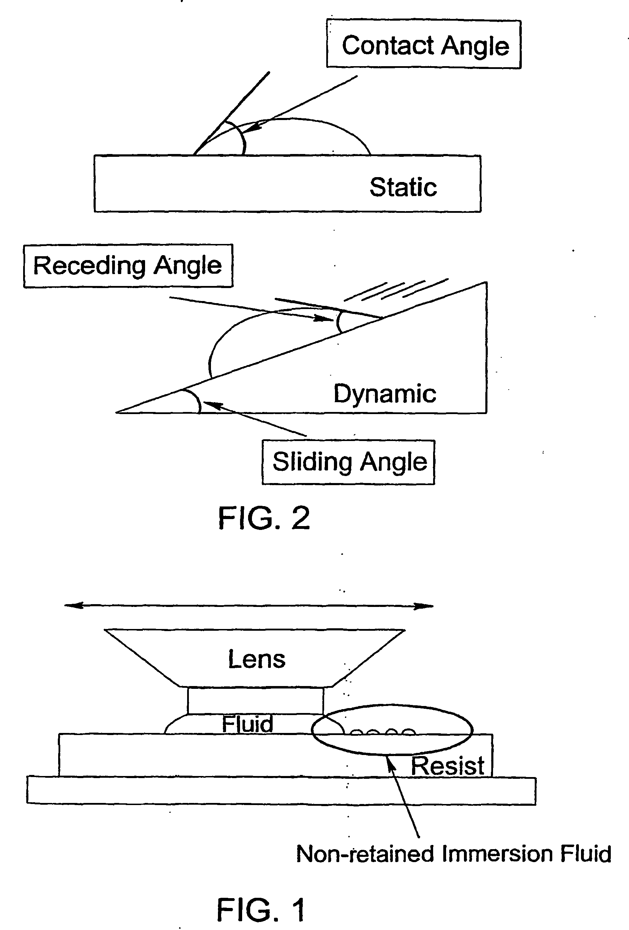

The terms "immersion material," "immersion medium," and "immersion fluid" are used interchangeably herein and refer to a fluid used to replace air in the exposure radiation pathway between a lens, used for focusing and directing the radiation, and a substrate. The fluid having a refractive index greater than air and less than any layer disposed between a lithographic tool's lens and the upper surface of a substrate, as depicted in Fig. 1.

The terms "non-retained immersion material," "non-retained immersion medium," and "non-retained immersion fluid" are used interchangeably herein and refer to portions of immersion material that is separated from the immersion medium disposed between a lithographic tool's lens and the upper surface of a substrate, as depicted in Fig. 1. Further to this definition, the terms "Scanability" and "Scan Speed Durability" are also used interchangeably herein and refer to the relative speed at which movement of the substrate with respect to the lens. Where an immersion medium is present, a measure of scanability includes whether or not any non-retained immersion material is formed. By way of example, for an immersion lithographic process, the designation of high scanability means that little or no non-retained immersion material is observed at an acceptable rate of lithographic tool motion.

The terms "Contact Angle," "Sliding Angle" and "Receding Angle" refer to the angles identified as such in Fig. 2. Further, the term "Rolling-down Angle" is used interchangeably herein with the term "siding Angle."

### Polymers

Some embodiments in accordance with the present invention, encompass a non-self imageable norbornene-type polymer having repeating units represented by I and IV, and optionally of Formulae II and /or III, shown below. Such embodiments encompass a composition that employs such a polymer for forming a top-coat or protective layer over a previously formed photoresist layer. The polymer being non-imageable, such a top-coat layer formed therefrom is also non-self imageable.

The top-coat layer is for receiving an immersion fluid (or medium) to enable an immersion photolithography process by serving to protect or isolate the photoresist or imaging layer from the immersion fluid. That is to say that the photoresist layer is physically removed (separated) from direct contact with the immersion fluid by the presence of the top-coat layer therebetween. In this manner, some or all of the aforementioned technical problems can be eliminated, avoided or at least their effects advantageously reduced. Further to such problems, such top-coat layer embodiments of the present invention are characterized by exhibiting advantageously high contact angles with aqueous fluids and are thus characterized as being hydrophobic. Such hydrophobicity is believed to be a desirable property for minimizing any chemical or other interactions between a material and an aqueous immersion fluid in contact therewith. Still further, such top-coat embodiments also exhibit high receding angles and low sliding angles (see, Fig. 2) which are believed to also be indicative of such materials having high hydrophobicity and therefore indicative of how such embodiments will dynamically perform during their use as a top-coat or protective layer for an immersion lithographic process. Thus it has been observed that when a top-coat layer exhibiting high contact and receding angles as well as low sliding angles, as compared to other materials, is used during an immersion lithographic process, little or no defectivity due to non-retained immersion fluid is observed over a wide range of scanning speeds. That is to say, such embodiments have excellent scanability.

In accordance with the present invention a non-self imageable polymer encompassing at least one repeating unit represented by Formula I : 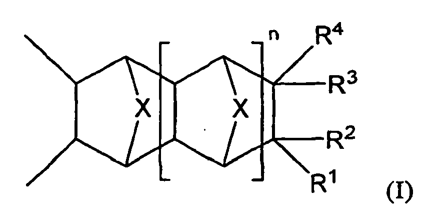 where X is -CH₂-, -CH₂CH₂-, O or S; n is an integer from 0 to 5 inclusive; each R¹ to R⁴ independently represents hydrogen, a linear or branched alkyl group, or a linear or branched haloalkyl group, subject to the proviso that at least one of R¹ to R⁴ is a QNHSO₂R⁵ group where Q is a linear or branched alkyl spacer of 1 to 5 carbon atoms, and R⁵ is a perhalo group of 1 to about 10 carbon atoms, and second type of repeating unit represented by Formula IV: 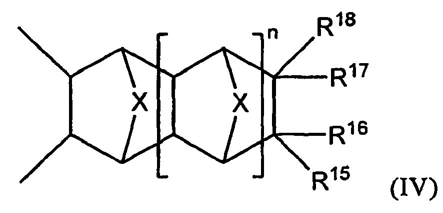 where X and n are as defined for Formula I and each of R¹⁵ to R¹⁸ independently represents hydrogen, a linear or branched alkyl group, or a linear or branched haloalkyl group, subject to the proviso that at least one of R¹⁵ to R¹⁸ is one of groups D, E or F: 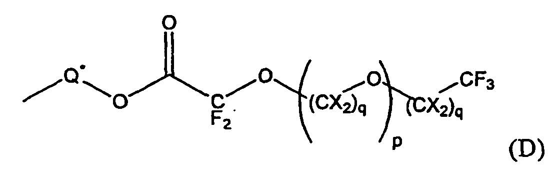 or 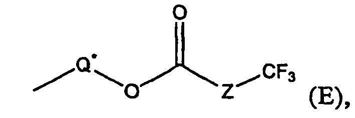 or 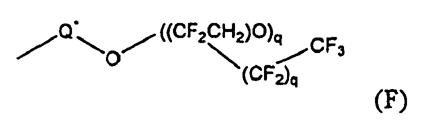 where each X is independently either F or H, each q is independently an integer from 1 to 3, p is an integer from 1 to 5, Q* is a linear or branched alkyl spacer of 1 to 5 carbon atoms, and Z is a linear or branched halo or perhalo spacer of 2 to 10 carbons atoms. is provided.

In some embodiments in accordance with the present invention the polymer unit represented by Formula I is such that where, subject to the aforementioned proviso, each of the others of R¹ to R⁴ that are not a QNHSO₂R⁵ group are independently hydrogen; a linear or branched alkyl or haloalkyl group of, for example from 1 to 20 carbon atoms, in some embodiments from 1 to 12 carbon atoms, and in other embodiments from 1 to 4 carbon atoms.

In some embodiments Q is a linear alkyl spacer of 1 to 3 carbon atoms and R⁵ contains from 1 to 4 carbon atoms. In other embodiments Q and R⁵ are each independently 1 or 2 carbon atoms, and in still other embodiments each is 1 carbon atom. Typically the halogen of R⁵ is selected from F, Br or I. In one exemplary embodiment of the present invention, X is -CH₂-, one of R¹ to R⁴ is a QNHSO₂R⁵ group and the others are each hydrogen, n is 0, Q is -CH₂-and R⁵ is -CF₃. Repeating units in accordance with Formula I are generally for providing the polymer with aqueous alkali solubility.

In some embodiments in accordance with the present invention the non-self imageable polymer further encompasses a third type of repeating unit represented by Formula II: 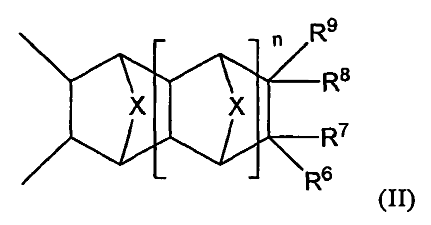 where X and n are as defined for Formula I and each of R⁶ to R⁹ independently represents hydrogen, a linear or branched alkyl group, or a linear or branched haloalkyl group, subject to the proviso that at least one of R⁶ to R⁹ is a -Q^{‡}(CO)O-(CH₂)ₘ-R¹⁰ group where Q^{‡} is an optional linear or branched alkyl spacer where if present is of 1 to 5 carbons, m is either 0 or an integer from 1 to 3 inclusive; and R¹⁰ is a linear or branched perhalo alkyl of 1 to 10 carbon atoms.

In some embodiments Q^{‡} is not present or is a linear alkyl spacer of 1 to 3 carbons and R¹⁰ contains from 1 to 4 carbon atoms. In other embodiments Q^{‡} is not present or is 1 carbon atom and R¹⁰ contains 1 or 2 carbon atoms, and in still other embodiments R¹⁰ contains 1 carbon atom. Typically the halogen of R¹⁰ is selected from F, Br or I. In exemplary embodiments of the present invention encompassing repeating units represented by Formula II, X is -CH₂-, one of R⁶ to R⁹ is the -Q^{‡}(CO)O-(CH₂)ₘ-R¹⁰ group and the others are each hydrogen, n is 0 and m is 1, Q^{‡} is not present and R¹⁰ is -C₂F₅. Repeating units in accordance with Formula II are generally for providing hydrophobicity control to the polymer and are generally used with other of the repeat units defined herein to provide such hydrophobicity control. That is to say that as more of such a repeating unit is incorporated into the polymer, the hydrophobicity of that polymer will generally increase.

In some embodiments in accordance with the present invention the non-self imageable polymer further encompasses a type of repeating unit represented by Formula III: 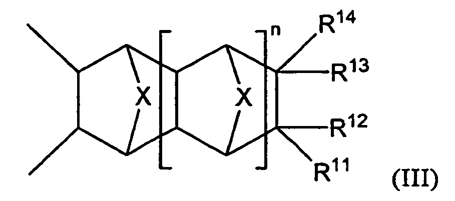 where X and n are as defined for Formula I and each of R¹¹ to R¹⁴ independently represents hydrogen, a linear or branched alkyl group, or a linear or branched haloalkyl group, subject to the proviso that at least one of R¹¹ to R¹⁴ is one of groups A, B or C: 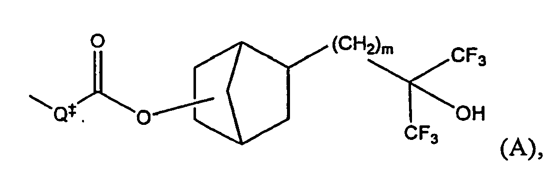 or 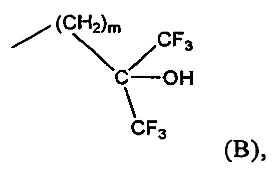 or 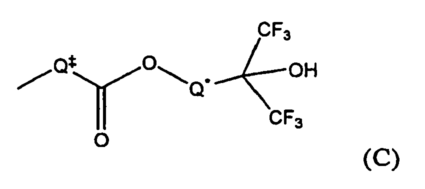 where m is an integer from 1 to 3 inclusive, Q^{‡} is as defined for Formula II and Q^{*} is a linear or branched alkyl spacer of 1 to 5 carbon atoms.

In some embodiments encompassing groups A or C, Q^{‡} is not present or is a linear alkyl spacer of 1 to 3 carbon atoms and additionally for group C, Q* is a linear or branched spacer of 3 or 4. In other such embodiments Q^{‡} is not present or is 1 carbon atom. In other embodiments encompassing group B, m is either 1 or 2. In exemplary embodiments of the present invention encompassing repeating units represented by Formula III, X is -CH₂-, one of R¹¹ to R¹⁴ is group B and the others are each hydrogen, n is 0 and m is 1. Repeating units in accordance with Formula III are generally for providing the polymer with aqueous alkali solubility and are generally used with other of the repeat units defined herein to provide such aqueous alkali solubility.

In some embodiments encompassing group D of repeating unit IV, Q* is one carbon, X is F, q is 2 or 3 and p is 2. In some embodiments encompassing group E, Q* is one carbon and Z is a branched fluorinated alkyl chain of up to 9 carbons units. In some embodiments encompassing group F, Q* is one carbon and q is 1 or 2. Repeating units in accordance with Formula IV are generally for providing hydrophobicity control to the polymer in the same manner as described for Formula II type repeating units.

It should be understood, that polymer embodiments of the present invention encompass polymers having repeating units represented by Formulae I and IV and other types of repeating units, including but not limited to repeating units such as those represented by one or more of Formulae II and/or III. For example, some embodiments encompass linear or branched alkyl substituted repeating units such as those derived from hexyl- or butyl-norbornene. Still other embodiments encompass repeating units derived from a linear or branched alkyl ester norbornene such as isobornyl ester norbornene. These alternate repeating units can be instead of, or in addition to, any of the previously mentioned repeat units that are represented by Formulae II, III.

Where an embodiment in accordance with the present invention encompasses a non-self imageable polymer having more than one distinct type of repeating unit represented by one or more of Formulae I, II, III and/or IV, the molar ratio of such repeating units, where repeating unit (I) is represented by Formula I, and the others of (2) through (m) are independently represented by Formulae II, III or IV, (1):(2): ... :(m) can be (30-99): (5-50): ... :(5-50), where m is an integer representing the last type of distinct repeating unit and generally is 4 or less. In other such embodiments such molar ratio can be (50-80):(5-30): ... :(5-30). It will of course be understood that for such ratios, the total cannot exceed 100. While where an embodiment encompasses Formulae I and IV type of repeat units and types of repeat units such as those represented by one of Formulae II or III, the mole percent (mol%) of the Formula I type of repeat unit is generally from 40 to 99 mol% and a sufficient amount of one or more of other types of repeat units are provided to provide 100 mol% of polymer. For exemplary embodiments, such as polymers having types of repeating units represented by formula IV one or both of Formulae III and IV in addition to types represented by Formulae I or Formulae I and II, the mol% of Formula I type of repeating units is typically from about 40 to 98 mol%, a Formula II type (if present) from about 1 to 20 mol% and independently, the unit of Formula IV from 1 to 40mol% and, it present, the unit of formula IV is from 1-40mol%. As will be discussed more fully below, the final formulation of a top-coat polymer is the result of certain design choices that are dictated by the manner in which a top-coat layer, formed from such a polymer, will be used.

It should further be noted that the specific amount of any particular repeating unit present within the polymer is the result of a "polymer design" process. That is to say, a repeat unit's physical and chemical properties are determined, often by forming a homopolymer thereof, and such physical and chemical properties compared to the desired properties of the layer to be formed. Based upon this comparison, one or more other repeat units are selected and test compositions of such polymers made and in turn formed into layers where physical and chemical properties are determined. As a non-limiting example of such a polymer design process, homopolymers of several norbornene-type monomers are formed and then cast into films for which contact and sliding angle measurements are made. Based on the measurements from the aforementioned homopolymers, a polymer having two or more types of repeating units can be formed having a high contact angle and a low sliding angle and/or desirable dissolution rate in an aqueous base solution such as 0.26N TMAH.

### Monomers and Polymerizations

The foregoing non-self imageable polymers represented by any one or more types of repeating units represented by appropriate Formulae I, II and IV and optionally further repeating units of Formulae II, III and /or IV are typically derived from appropriate analogous monomers. Thus, by way of a non-limiting example, where a repeating unit such as: 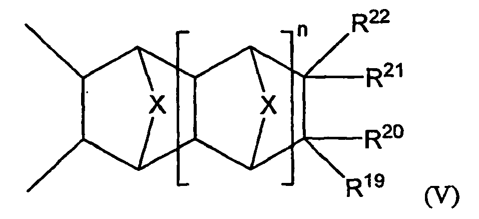 is desired, the analogous monomer, shown below, can be employed in the forming of the polymer:

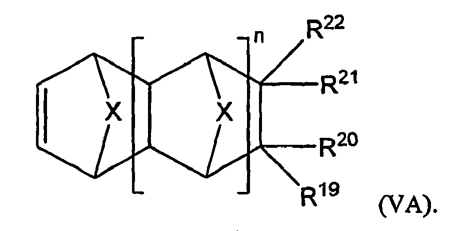

Thus, where a polymer having a first type of repeating unit represented by Formula I and a second type of repeating unit represented by, Formulae IV as well as further unit(s) of formulae II, III and/or V is desired, such polymer can be prepared by addition polymerization (2, 3 enchainment) of appropriate, analogous monomers of the desired repeating units; where such addition polymerizations is carried out in the presence of a single or multi-component Group VIII transition metal catalyst.

Where a multi-component catalyst is desired, such can be prepared in situ by combining a procatalyst with a cocatalyst (or activator) in the presence of the monomer(s) to be polymerized. By procatalyst is meant a Group VIII transition metal (generally palladium) containing compound that is converted to an active catalyst by a reaction with a cocatalyst or activator compound. The description and synthesis of representative procatalysts and cocatalysts, as well as cationic Pd(II) catalysts formed there using, are known. For example, as set forth in U.S. Patent No. 6,455,650. Where a single component catalyst is desired, such catalysts are (and some additional multi-component catalyst systems) set forth in published U.S. Patent Application No. 20050187398. The catalyst systems of such referential documents are briefly described below, however, it will be understood that such descriptions provided herein are non-limiting examples and hence are not all encompassing. A more complete description of such catalyst systems is provided by the above-referenced documents.

Palladium procatalysts suitable for the polymerization of the monomers of the present invention are represented by Formula A, below:

(Allyl)Pd(P(R^{x})₃)(L') (A)

where R^{x} may be isopropyl or cyclohexyl; and L' may be trifluoroacetate or trifluoromethanesulfonate (triflate). Representative procatalyst compounds in accordance with such formula include, but are not limited to, (allyl)palladium-(tricyclohexylphosphine)triflate, (allyl)palladium (triisopropylphosphine) triflate, (allyl) palladium (tricyclohexylphosphine)trifluoroacetate, and (allyl)palladium (triisopropylphosphine)trifluoroacetate.

Other suitable procatalysts are described in the aforementioned '650 patent encompass a palladium metal cation and a weakly coordinating anion as represented by Formula B shown below:

[(E(R)₃)ₐPd(Q)(LB)_{b}][WCA]ᵣ (B)

where E(R)₃ represents a Group 15 neutral electron donor ligand where E is selected from a Group 15 element of the Periodic Table of the Elements, and R independently represents hydrogen (or one of its isotopes), or an anionic hydrocarbyl (and its deutero versions) containing moiety; Q is an anionic ligand selected from a carboxylate, thiocarboxylate, and dithiocarboxylate group; LB is a Lewis base; WCA represents a weakly coordinating anion; a represents an integer of 1 or 2; and b represents an integer of 1 or 2 where the sum of a + b is 3.

Suitable single component catalysts are described in the aforementioned published application and are represented by Formulae B' and C, below:

[(E(R)₃)ₐPd(Q)(LB)_{b}]p[WCA]ᵣ (B')

[(E(R)₃)(E(R)₂R*)Pd(LB)]ₚ[WCA]ᵣ (C)

In Formula B', E, R, E(R)₃; Q; LB and WCA are as defined above for Formula B, but where a represents an integer of 1, 2, or, 3; b represents an integer of 0, 1, or 2, where the sum of a + b is 1,2, or 3; and p and r are integers that represent the number of times the palladium cation and the weakly coordinating anion are taken to balance the electronic charge on the structure of Formula B'. In an exemplary embodiment, p and r are independently selected from an integer of 1 and 2.

In Formula C, E(R₃) is as defined for Formula B'; E(R)₂R* also represents a Group 15 neutral electron donor ligand where E, R, r and p are defined as above and where R* is an anionic hydrocarbyl containing moiety, bonded to the Pd and having a β hydrogen with respect to the Pd center. In an exemplary embodiment, p and r are independently selected from an integer of 1 and 2. While such single component catalysts systems can advantageously be employed without the addition of a cocatalyst (that is to say as a latent catalyst activated only by the addition of energy, for example by heating), typically where such single component catalysts are used for a solution polymerization, the addition of an amount of cocatalyst is often desirable.

Representative cocatalyst compounds include, among others, lithium tetrakis(pentafluorophenyl)borate diethyl etherate (LiFABA) and N-dimethylanilinium tetrakis-(pentafluorophenyl)borate (DANFABA). Other suitable activator compounds are also described in the aforementioned '650 patent.

In accordance with some multi-component catalyst embodiments of the present invention, monomer to catalyst to cocatalyst molar ratios can range from 500:1:5 to 20,000:1:5 or from 500:1:1 to 20,000:1:1. In some such embodiments, molar ratios are from 5,000:1:4 to 1,000:1:2, and in still other such embodiments, molar ratios of from 3,000:1:3 to 1,000:1:2 are advantageous. It should be recognized that appropriate molar ratios can and will vary depending, among other things, on the activity of a particular catalyst system, the reactivity of the monomer selected, and molecular weight of the resulting polymer that is desired. In addition, for embodiments of the present invention where single component catalysts are employed, the addition of a cocatalyst can be eliminated. However, generally a ratio of from 5,000:1:4 to 5000:1:2, and in particular of 2000:1:3 to 1000:1:3 have been found useful.

Suitable polymerization solvents for the addition polymerization reactions include aliphatic and aromatic solvents. These include aliphatic (non-polar) hydrocarbons such as pentane, hexane, heptane, octane and cyclohexane; halogenated alkane solvents such as dichloromethane, chloroform, carbon tetrachloride, ethyl chloride, 1,1-dichloroethane, 1,2-dichloroethane, 1-chloropropane, 2-chloropropane, 1-chlorobutane, 2-chlorobutane, 1-chloro-2-methylpropane, and 1-chloropentane; esters such as ethylacetate, i-amyl acetate; ethers such as diethylether; aromatic solvents such as benzene, toluene, o-, m-, and p-xylene, mesitylene, chlorobenzene, o-dichlorobenzene, Freon® 112 halocarbon solvent, fluorobenzene, o-difluorobenzene, p-difluorobenzene, pentafluorobenzene, hexafluorobenzene, and o-dichlorobenzene. Water may be used as the solvent. Other organic solvents such as diethyl ether, tetrahydrofuran, acetates (e.g., ethyl acetate), esters, lactones, ketones and amides may be useful. Mixtures of two or more of the aforementioned solvents may be useful.

In a solution process, the polymerization reaction may be carried out by adding a solution of the preformed catalyst or individual catalyst components to a solution of the norbornene-type monomer or mixtures of monomers to be polymerized. In some embodiments, the amount of monomer dissolved in the solvent ranges from 5 to 50 weight percent (wt%), and in other embodiments from 10 to 30 wt%, and in still other embodiments from 10 to 20 wt%. After the preformed catalyst or catalyst components are added to the monomer solution, the reaction medium is agitated (e.g. stirred) to ensure complete mixing of catalyst and monomer components and is generally heated for a period of time adequate for the polymerization.

While the reaction temperature of the polymerization reaction can range from 0°C to 150°C, generally temperatures from 10°C to 100°C, or even from 20°C to 80°C have been found to be advantageous.

In top-coat polymer embodiments of the invention, a desired average molecular weight (Mw) of the polymers is from 3000 to 200,000. In other embodiments, Mw is from 3500 to 50,000 and in still other embodiments from 4000 to 10,000. In photoresist polymer embodiments of the invention, a desired Mw of the polymers is from 2000 to 50,000. In other embodiments, Mw is from 2500 to 35,000 and in still other embodiments from 3000 to 10000. However, it should be understood that other embodiments in accordance with the present invention encompass top-coat and photoresist polymers having other average molecular weight ranges, and that such polymers can have either a higher or lower Mw that is provided with the exemplary Mw ranges above. Further to the Mw ranges provided above, it will be noted that Mw for any polymer referred to herein is measured using gel permeation chromatograph (GPC) with an appropriate standard, unless otherwise noted.

### Polymer Compositions

Some embodiments in accordance with the present invention encompass compositions of either the top-coat polymer embodiments or photoresist polymer embodiments previously discussed, where such compositions can incorporate an appropriate polymer having any of the appropriate repeating units in the molar ratios and M_{w} ranges previously disclosed. Such compositions are useful for forming a film overlaying a substrate as will be discussed in more detail below. Such compositions will encompass an appropriate polymer, a solvent and one or more additional components (additives) that are selected to provide for the forming of a film over a substrate, e.g. a semiconductor substrate, and/or enabling the desired performance of such a film during an immersion lithographic process.

Referring first to embodiments of the present invention that are compositions encompassing a top-coat polymer, such compositions encompass appropriate amounts of one or more distinct top-coat polymers, such as described above, an organic solvent and optionally, one or more of an acidic material, a cross-linking material and a surfactant.

Useful organic solvents for a top-coat composition are solvents capable of dissolving the polymer while not being miscible with a photoresist film previously formed on a substrate. Such solvents generally includes alcoholic solvents having from 1 to 10 carbon atoms, partially or wholly-fluorinated alcoholic solvents having from 1 to 10 carbon atoms, partially or wholly-fluorinated alkyl ether solvents having from 4 to 15 carbon atoms, and partially or wholly-fluorinated alkyl ester solvents having from 4 to 15 carbon atoms. Exemplary solvents in accordance with the above criteria are n-butyl alcohol, isobutyl alcohol, n-pentanol, 4-methyl-2-pentanol, 2-octanol, 2-perfluorobutyl ethanol (C₄F₉CH₂CH₂OH) perfluoropropyl methanol ((C₃F₇)(CH₂OH)), H(CF₂)₂CH₂-O-(CF₂)₂-H, H(CF₂)₇-(CO)O- CH₃ and H(CF₂)₄-(CO)O- C₂H₅.

Optionally, top-coat composition embodiments of the present invention can include an acidic compound. Advantageously, such an acid compound can, if present, serve as a "post-exposure delay" protective agent. That is to say, should there be a delay in the timing between the imagewise exposure of an underlying photoresist film and the development of the formed image, such acid compound can serve to provide protection against the effect of any atmospheric amines or amine-containing materials that may be present. Such protection being afforded by the acidic compound reacting with any such atmospheric amines to neutralize them before such amines can interact with the exposed photoresist film to result in miss-patterning of the photoresist film during a delayed, subsequent development process. Thus by including an optional acidic compound in the top-coat composition, it may be possible to reduce or eliminate any significant dimensional fluctuation of the photoresist pattern resulting from the presence of atmospheric amines or amine-containing compounds.

Useful acidic compounds are those represented in the Formulae shown below:

(CₚF₂ₚ+₁SO₂)₂NH X

where p is an integer of from 1 to 5,

C_{q}F_{2q}+₁COOH XI

where q is an integer of from 10 to 15, 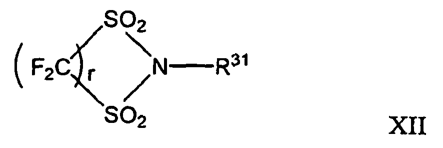 where r is an integer of 2 or 3, R³¹ represents hydrogen or an alkyl group partially or wholly substituted with fluorine atoms, such alkyl group further being optionally substituted with any of a hydroxyl group, an alkoxy group, a carboxyl group and an amino group. 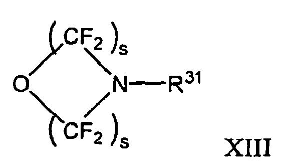 where s is an integer of 2 or 3, and R³¹ is as defined above.

Exemplary acidic compounds are (C₄F₉SO₂)₂NH, (C₃F₇SO₂)₂NH, C₁₀F₂₁COOH, 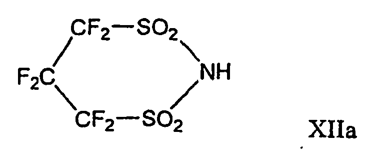 and

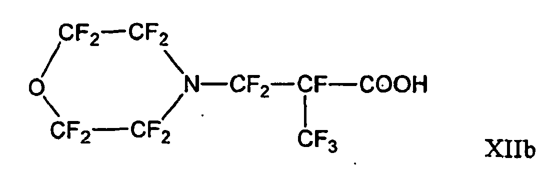

In some top-coat composition embodiments of the present invention, an optional crosslinking agent is added. Such optional crosslinking agents are generally a nitrogen-containing compound which has an amino group and/or an imino group and in which at least two hydrogen atoms are substituted with a hydroxyalkyl group and/or an alkoxyalkyl group. Such agents include, but are not limited to, melamine derivatives, urea derivatives, guanamine derivatives, acetoguanamine derivatives, benzoguanamine derivatives and succinylamide derivatives in which the hydrogen atom of the amino group is substituted with a methylol group or an alkoxymethyl group or with both of the two; as well as glycoluryl derivatives and ethylene-urea derivatives in which the hydrogen atom of the imino group is substituted. An exemplary crosslinking agent is tetrabutoxy methylated glycoluryl.

These nitrogen-containing compounds may be obtained, for example, by reacting a melamine derivatives, an urea derivative, a guanamine derivative, an acetoguanamine derivative, a benzo-guanamine derivative, a succinylamide derivative, a glycoluryl derivative or an ethylene-urea derivative with formalin in boiling water to thereby methylate the derivative, or by further reacting it with a lower alcohol, concretely methanol, ethanol, n-propanol, isopropanol, n-butanol or isobutanol to thereby alkoxylate it. One exemplary crosslinking agent found useful is tetrabutoxy methylated glycoluryl.

Other crosslinking agents have also been found useful. For example a condensation product of at least one type of a hydrocarbon compound substituted with a hydroxyl group and/or an alkoxy group, and a monohydroxy-monocarboxylic acid compound is also included. Exemplary condensation products include monohydroxy-monocarboxylic acids in which the hydroxyl group and the carboxyl group are bonded to either a single carbon atom or to adjacent carbon atoms.

If desired, the protective film-forming composition in accordance with embodiments of the invention can further contain an optional surfactant added thereto. One exemplary surfactant is XR-104 (trade name by Dainippon Ink and Chemicals, Inc.), to which, however, the invention should not be limited. Adding the surfactant to the material makes it possible to further improve the coatability of the material and the ability thereof to provide for a more uniform application of the top-coat or protective film. This increased uniformity being the result of suppressed unevenness in the film.

Top-coat composition embodiments of the present invention are employed for forming top-coat or protective-layer films overlying a photoresist film formed on a substrate. Such films are generally for receiving an immersion fluid such as is employed in an immersion lithographic process. Generally the thickness of such a top-coat film, in some embodiments, is from 70 nm to 200 nm, while in other embodiments from 90nm to 180 nm and in still other embodiments, from 120nm to 160 nm. It will be understood, however, that other film thicknesses, greater than or less than the ranges provided above are also useful and thus are within the scope and spirit of the embodiments of the present invention. It will also be understood, that obtaining any particular film thickness from the appropriate use of a top-coat composition of the present invention is dependent on the method of coating employed as well as the amount of top-coat polymer, and of any optional additives present, within such a composition. Where a spin coating method is used (described more fully below) it is found that for some embodiments a desirable range of the amount of top-coat polymer is from 0.1 weight percent (wt%) to 30 wt%, while in other embodiments such amount is from 0.3 wt% to 15 wt% and in still other embodiments from
0.5 wt% to 7.5 wt% is desirable. Such values of wt% being with respect to the total amount (weight) of such top-coat composition. It will be understood, however, that ranges for the amount of top-coat polymer, greater than or less than the ranges provided above are also useful and thus are within the scope of the embodiments of the present invention.

When an optional surfactant is added to such a top-coat composition, some embodiments employ a range of such surfactant of from 0.001 wt% to 10 wt%, other embodiments from 0.01 wt% to 1 wt%, and still other embodiments from 0.05 wt% to 0.5 wt%, such amounts being with respect to the amount of top-coat polymer in such a composition. When an optional crosslinking agent is added to such a top-coat composition, some embodiments employ a range of such agent of from 0.5 wt% to 10 wt%, other embodiments from 1 wt% to 8 wt%, and still other embodiments from 3 wt% to 7 wt%, such amounts being with respect to the amount of top-coat polymer in such a composition. And when an optional acidic compound is added to such a top-coat composition, some embodiments employ a range of such acidic compound of from 0.1 wt% to 10 wt%, other embodiments from 0.2 wt% to 5 wt%, and still other embodiments from 0.3 wt% to 1 wt%, such amounts being with respect to the amount of top-coat polymer in such a composition.

In some embodiments of the present invention, other optional additives are employed. All such optional additives are miscible and are selected for being included into a composition according to need. That is to say, for improving certain of the properties of the composition or of the resulting layer. Exemplary optional, miscible additives include, but are not limited to, surfactants for improving the ease of application, dissolution inhibitors, plasticizers, stabilizers, colorants and halation prevention agents.

### Immersion Lithographic Processes

Some immersion lithographic process embodiments in accordance with the present invention use previously described imageable polymer composition embodiments (photoresist compositions) for forming a imageable layer overlying a substrate, for example a semiconductor substrate. In such embodiments, a photoresist composition is first applied to the surface of a substrate such as a silicon wafer using a spinner to form a photoresist layer having a first desired thickness. The layer is then prebaked and imagewise exposed, for example using ArF excimer laser (193 nm) through a desired mask pattern. After exposure, the layer is post exposure baked (PEB) and then after cooling, the image is developed using an alkali developing liquid. Generally the prebake is at from 70°C to 140°C for 40 to 120 seconds, and in some embodiments for 60 to 90 seconds (sec). PEB is generally conducted using the same or similar times and temperatures to the prebake process. The alkali developing liquid is generally a 0.1 to 10 wt% aqueous solution of tetramethylammonium hydroxide (TMAH) and typically a 0.26N TMAH solution. In this manner, a resist pattern faithful to the mask pattern is obtained.

Furthermore, while ArF excimer lasers are found advantageous for the imaging of the photoresist layers formed from imageable polymer compositions of the present invention, it should be noted that other types of radiation are also effective for forming patterned photoresist layers. For example, longer wavelengths such as 365 nm and shorter wavelengths such as obtained from F₂ lasers, EUV (extreme ultraviolet radiation) sources, VUV (vacuum ultraviolet radiation) sources, electron beams, X-rays and soft X-rays can also be effectively used

In some image forming process embodiments of the present invention, previously described top-coat polymer composition embodiments are used to form a protective layer over a previously formed photoresist layer before such layer is imagewise exposed. Generally for such embodiments, after casting the photoresist layer over the substrate and the prebake of such layer, a top-coat composition is second applied over the photoresist layer using a spinner to form a top-coat layer thereon, such top-coat layer having a second desired thickness. After the top-coat layer is cast, it is prebaked in an analogous manner to that described above for the photoresist layer. After the top-coat layer is prebaked, the underlying photo-resist layer is imagewise exposed as previously described and then subjected to PEB and image development. Advantageously, the top-coat layers of the present invention are soluble in the aqueous alkali developer solutions used. Therefore, upon exposure to such a solution, the top-coat layer is readily removed to completely present the photoresist layer to the developer solution. In this manner a resist pattern faithful to the mask pattern is obtained without the need for a separate top-coat removal step. It should be noted that top-coat layer forming compositions of the present invention are suitable for use with any appropriate photoresist material, where by appropriate it is meant a material that exhibits little or no intermixing with the protective layer forming composition.

The following description of a lithographic system, which may be used with the foregoing top-coat compositions and/or photoresist compositions as each are formed, is presented in the exemplary context of fabricating a plurality of integrated circuits (IC) formed on/in a semiconductor substrate (wafer). Exemplary ICs include general purpose microprocessors made from thousands or millions of transistors, dynamic, static or flash memory arrays or any other dedicated circuitry. However, one skilled in the art will appreciate that the methods and devices described herein can also be applied to the fabrication of any article manufactured using lithography, such as micro-machines, disk drive heads, gene chips, micro electro-mechanical systems (MEMS), and the like.

An exemplary IC processing arrangement can include an immersion lithographic system used to image a pattern onto a wafer or a region of the wafer. A photoresist composition or imaging layer overlies the wafer. The lithographic system may be, for example, a step-and-repeat exposure system or a step-and-scan exposure system, but is not limited to these exemplary systems. The lithographic system can include a light source and lens array or structure for directing light energy towards a mask (sometimes referred to as a reticle) and then to the imaging layer over the substrate. While the light energy typically has a wavelength of 193 nm, other wavelengths, such as 157 nm or 248 nm can also be employed.

The mask selectively blocks light energy such that a light energy pattern defined by the mask is transferred towards the wafer. An imaging subsystem, such as a stepper assembly or a scanner assembly, sequentially directs the energy pattern transmitted by the mask to a series of desired locations on the wafer. The imaging subsystem may include a series of lenses and/or reflectors for use in scaling and directing the energy pattern towards the wafer in the form of an imaging (or exposure) light energy pattern.

The imaging pattern (or exposure pattern) is transmitted by the imaging subsystem through an immersion medium, that will generally have a relatively high index of refraction (e.g., an index of refraction greater than 1 but less than the index of the imaging layer). The immersion medium is generally a liquid. In one example, purified de-ionized water is used in conjunction with a 193 nm light source (e.g., an argon fluorine (ArF) laser).

The top-coat composition embodiments in accordance with the present invention can be used in forming a top-coat layer overlying a photoresist imaging layer. Such a top-coat layer receives the immersion material and prevents or inhibits ingress of such immersion medium, or components thereof, into the underlying imaging layer. In this manner deleterious effects in imaging can be prevented or at least inhibited. Such deleterious effects are effects that result from the aforementioned problems.

Thus, in some embodiments in accordance with the present invention, a process for generating an image on a substrate encompasses: (a) first coating a substrate with a photoresist composition to form an imaging layer thereon; (b) second coating a substrate with a top-coat composition in accordance with the present invention to form a top-coat layer overlying the imaging layer; (c) imagewise exposing the substrate and overlying layers to appropriate radiation; and (d) developing an image. While in other embodiments the aforementioned first coating employs a photoresist composition in accordance with the present invention and does not include a second coating, and in still other embodiments, both the first coating and the second coating employ appropriate compositions of the present invention. It should be further noted that for step (a), above, the photoresist composition can be essentially any composition that when formed into a layer, has essentially no interaction with the top-coat polymer or the solvent used to form the castable composition thereof.

For each of the above described processes, the first coating involves coating the substrate with a film encompassing a photoresist composition. Suitable substrates encompass silicon, ceramics, polymer or the like. Suitable photoresist compositions can be those in accordance with the present invention, that is to say compositions that encompass a polymeric material embodiment of the present invention, as well as other photoresist compositions. The second coating, if performed, serves to overlay the imaging layer with a film formed from a top-coat composition in accordance with the present invention. Such top-coat layer or film being typically formed in a manner analogous to the forming of the photoresist layer. Imagewise exposing encompasses, exposing selected portions of the imaging or photoresist layer to appropriate radiation Finally, developing the image encompasses first removing any top-coat layer that may have been formed and then development of the image created by the imagewise exposure. Since any top-coat layer formed using a top-coat composition in accordance with the present invention is soluble in aqueous base type solvents such as are also used for developing images in typical imaging layers, embodiments of the present invention can utilize the same solvent for both top-coat removal and image developing. In some embodiments, a unitary process can be employed for both top-coat removal and image development. Suitable solvents include aqueous base solutions, for example, an aqueous base without metal ions, such as tetramethylammonium hydroxide or choline.

The present invention also relates to an integrated circuit assembly such as an integrated circuit chip, multichip module, or circuit board made by the process of the present invention. The integrated circuit assembly encompasses a circuit formed on a substrate by any of the coating, exposing and developing processes described above.

After the substrate has been exposed, developed and etched, circuit patterns can be formed in the exposed areas by coating the substrate with a conductive material such as conductive metals by art known techniques such as evaporation, sputtering, plating, chemical vapor deposition, or laser induced deposition. The surface of the film can be milled to remove any excess conductive material. Dielectric materials may also be deposited by similar techniques during the process of making circuits. Inorganic ions such as boron, phosphorous, or arsenic can be implanted in the substrate in the process for making p or n doped circuit transistors. Other techniques for forming circuits are well known to those skilled in the art.

Photoresist layers and/or top-coat layers employing compositions in accordance with the present invention can be formed by a known spin coating technique, or any other appropriate coating method. The top-coat composition can be applied over any photoresist imaging layer to form an overlying layer by such coating methods. The thickness of a top-coat or an imaging layer formed using appropriate compositions that are embodiments of the present invention is generally in the range of from 10 nanometers (nm) to 300nm. In some embodiments, it can be from 20 nm to 200 nm and in other embodiments from 30 nm to 160 nm. It should be noted that other thicknesses of both top-coat and imaging layers, greater or less than any of the ranges provided above can also be found useful and thus are within the scope of the present invention.

Typically, once formed, the top-coat layer exhibits one or more of the following desirable properties: 1) rapid dissolution in an aqueous base developer (for example, 0.26 N tetramethylammonium hydroxide (TMAH)); 2) high transparency at the wavelength used for imagewise exposure, for example, 193 nm and/or 3) an appropriate refractive index, for example, a refractive index of about 1.5 at 193 nm. The first property is desirable so that the topcoat layer is readily integrated into a typical patterning process flow. The second property is desirable so that the top-coat layer does not interfere with the lithographic performance of the imaging layer. The third property can be desirable where, if required, the top-coat layer can act as an anti-reflective layer when water is used as the immersion layer.

The following examples include detailed descriptions of polymerizations, and the monomers used therein. Such descriptions may be used to prepare the polymers employed in the embodiments of the present invention. While these examples and the materials described therein fall within the scope of embodiments of the present invention they are presented for illustrative purposes only, and are not intended as a restriction on such scope. Other examples presented herein relate to characteristics of the polymers and polymeric compositions that are embodiments of the present invention. Such characteristics are of interest for enabling polymer design embodiments of the present invention as well as for demonstrating that such polymer and polymer compositions of the present invention are useful for immersion lithography processes as described herein.

As used in the polymerization examples and throughout the specification, ratios of monomer to catalyst and cocatalyst are molar ratios. Further, in the examples the terms "sparging" or "sparged" are used repeatedly, such terms will be understood to refer to the passing of nitrogen gas through a liquid to remove dissolved oxygen. Still further, a number of acronyms or abbreviations are used in the examples. To aid in the understanding of these examples, the following listing of such acronyms or abbreviations with their full meaning is provided below:
- **Acid NB:**: Bicyclo[2.2.1]hept-5-ene-2-carboxylic acid
- **THF:**: Tetrahydrofuran
- **MeOH:**: Methanol
- **PGMEA:**: Propyleneglycol methylether acetate
- **M_{w}:**: Weight average molecular weight
- **Mₙ:**: Number average molecular weight
- **PDI:**: Polydispersity (PDI = M_{w}/Mₙ)
- **¹H-NMR:**: Proton nuclear magnetic resonance spectroscopy
- **¹⁹F NMR:**: Fluorine nuclear magnetic resonance spectroscopy
- **¹³C NMR:**: Carbon nuclear magnetic resonance spectroscopy
- **Pd 1206:**: (Acetonitrile)bis(triisopropylphosphine)palladium(acetate) tetrakis(pentafluorophenyl)borate
- **Pd 1394:**: (Acetonitrile)bis(t-butyldicyclohexylphosphine)palladium (acetate)tetrakis(perfluorophenyl)borate.
- **LiFABA:**: lithium tetrakis(pentafluorophenyl)borate diethyl etherate
- **DANFABA:**: N- dimethylanilinium tetrakis-(pentafluorophenyl)borate

Additionally, the following monomer and monomer precursor structures, shown in Structural Groups AA, BB and CC with appropriate acronyms or abbreviations, are provided to further aid in the understanding of the examples. Further it should be noted that of the structures shown in Group BB, the monomer labeled PPVENB was obtained from DuPont FluoroIntermediates of Wilmington, Delaware and the monomers labeled C10FAcNB, C8AcNB, C8GAcNB, C9BrAcNB, C10BrAcNB and FHCNB were obtained from Exfluor Research Corporation of Round Rock, Texas.

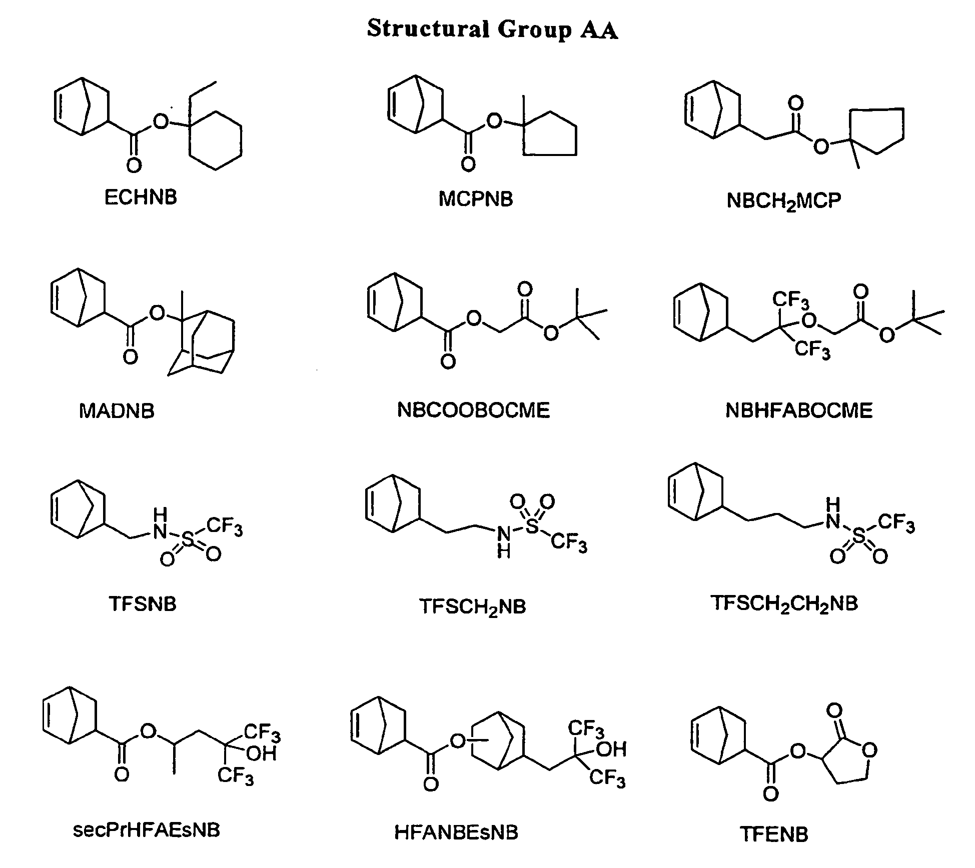

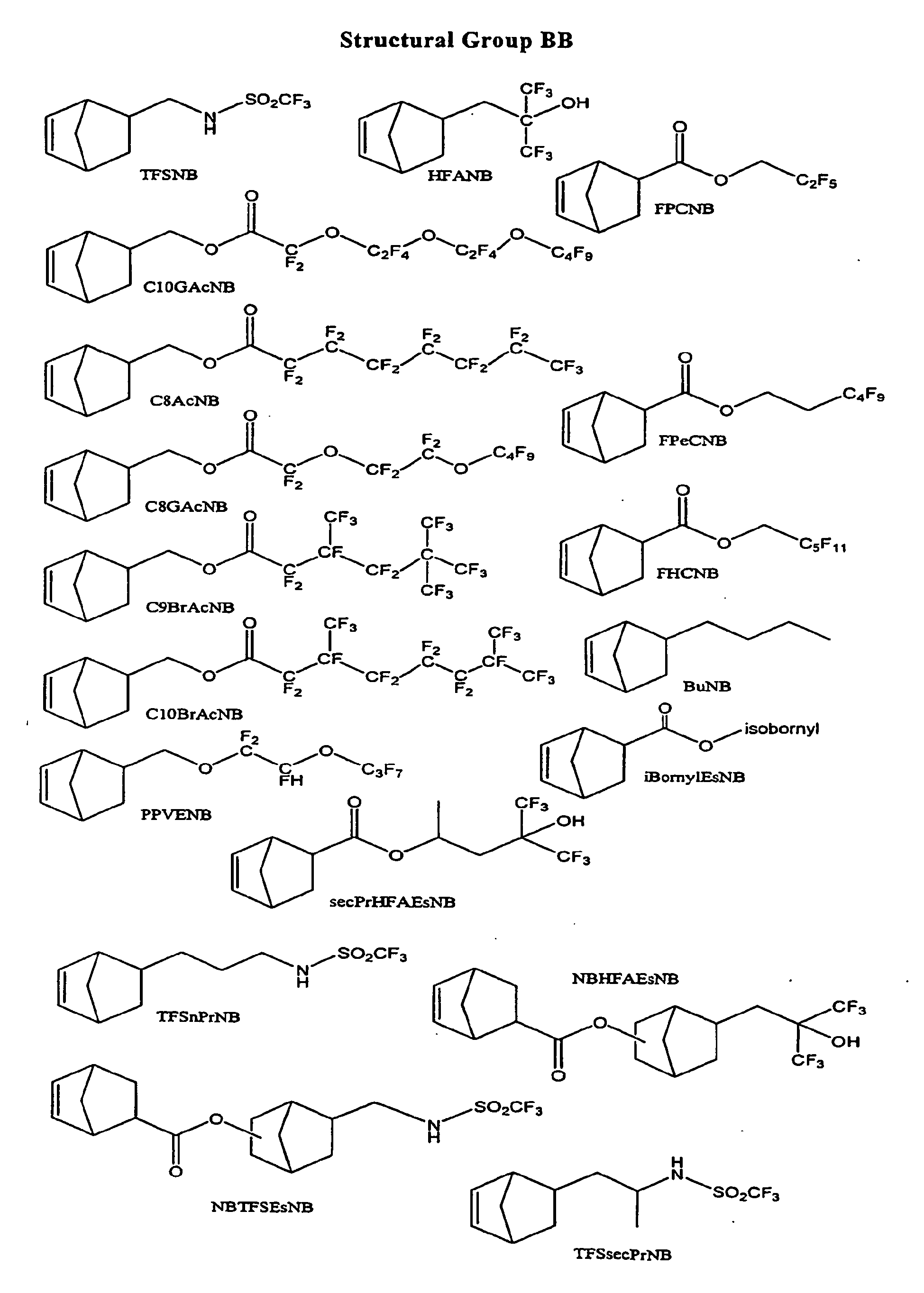

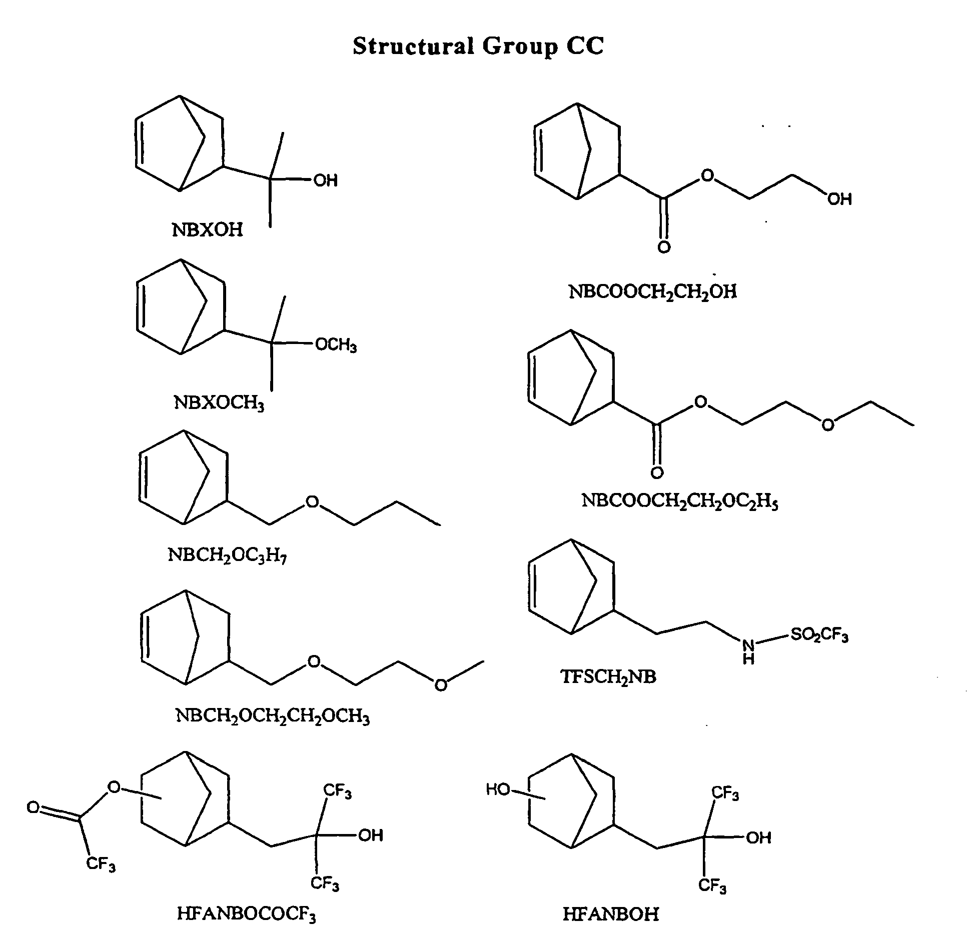

Measurements of CA, SA and dissolution rate were made by one of two sets of procedures. For each of the measurements in each set, a film of interest is cast on a substrate and the measurements reported are of that film. Where applicable, examples P4-P29, measurement set 1 was employed and for other examples measurement set 2 was used.

Measurement Set 1: (a) **contact angle:** 3 µL drops of pure water were placed at three different locations on the wafer and contact angle of the droplet at each location was determined using a commercial contact angle goniometer (Ramé-Hart model #100-00). The value reported is the mean of the three measurements; (b) **sliding angle:** a 50 µL was dispensed onto a coated substrate positioned in a proprietary instrument which can increase an incline angle of the substrate from a horizontal position (incline angle = 0). The incline angle at which the drop began to slide was taken at the sliding angle. The value reported is an average of two measurements; (c) **dissolution rate:** the film of interest was cast from a 20% solution of the polymer of interest dissolved in isobutanol. The casting process is adjusted to get a cast film of about 300mum ± 75nm. Initial film thickness and the Cauchy parameters A and B were determined by ellipsometry. Samples were then immersed in 0.26 N tetramethyl ammonium hydroxide (TMAH) for three seconds, withdrawn, rinsed with de-ionized water and dried using a stream of dry nitrogen. After drying, film thickness was remeasured and dissolution rate reported as the change in thickness divided by the time of immersion. Where the substrate was completely cleared of film at the remeasure, a dissolution rate of>100 nm/sec was reported.

Measurement Set 2: (a) **contact angle:** the film was cast to have a thickness of about 140 nm. In an environment at a temperature of about 25°C and a relative humidity of 50 %, 2 µl of pure water was dropped onto the film, using "Drop Master 700" (by Kyowa Interface Science Co., Ltd.); (b) **sliding angle** measurements. The rolling-down angle or sliding angle was determined as follows: The protective film-forming material was applied onto a silicon wafer to form thereon a protective film having a thickness of 140 nm. In an environment at room temperature of 25°C and at a humidity of 50 %, 50 µl of pure water was dropped onto the substrate at an inclination speed of 1°/sec, using "Drop Master 700" (by Kyowa Interface Science Co., Ltd.); (c) The **dissolution rate** (solubility) in developer was determined as follows: The protective film-forming material was applied onto a silicon wafer to form thereon a protective film having a thickness of 350 nm. Using "RDA-800" (by Litho Tech Japan Co., Ltd.), the substrate was kept in contact with an aqueous 2.38 wt% TMAH solution (23.5°C) for 120 seconds. Waterproofness was determined as follows: The protective film-forming material was applied onto a silicon wafer to form thereon a protective film having a thickness of 140 nm. Using "D-SPIN8" (by Dainippon Screen MFG Co., Ltd.), the substrate was kept in contact with pure water (23.5°C) for 120 seconds.

Optical Density (OD) measurements. Samples were prepared by spin coating a 1-inch quartz wafer with an approximately 15 wt% solution of the desired polymer, typically in propylene glycol methylether acetate (PGMEA). After the samples were baked for 60 sec at 130 °C on a hotplate and allowed to cool, the optical absorbance of each was measured at 193 nm using a Cary 400 Scan UV-Vis spectrophotometer. A blank quartz wafer was used in the reference beam. To determine each samples film thickness, a portion of the film was removed from the quartz wafer and the thickness measured using a Tencor profilometer. Optical density was calculated as absorbance/thickness (in microns). It should be noted that all OD measurements provided values sufficiently low to allow for exposure of an underlying photoresist layer without noticeable image degradation.

### Monomer Synthesis Examples

### Example MS1 secPrHFAEsNB

Dicyclopentadiene (60 g, 0.45 mol) was charged to a 200 mL round bottomed flask equipped with a short-path distillation head. The flask was heated to collect the cyclopentadiene distillation fraction at 30-32 °C. In a separate 500 mL, 3-neck round bottomed flask maintained in a nitrogen atmosphere, acrylic acid 4,4,4-trifluoro-3-hydroxy-1-methyl-3-trifluoromethyl-1-butyl ester (50 g, 0.18 mol) and toluene (125 mL) charged. Separately, cyclopentadiene obtained from the distillation (22-23 mL, 0.28 mol) was added by syringe through a rubber septum. After this addition, the flask and its contents was heated to about 35°C and maintained at that temperature until gas chromatographic (GC) analysis of the reaction mixture indicated a complete conversion of the starting materials, about 19 hours. The product in toluene was concentrated using a rotary evaporator and distilled under reduced pressure using a short-path distillation head to obtain the secPrHFAEsNB monomer product at between about 65-70°C/170 mmHg. The yield of 99% pure monomer, determined by GC was about 95%. The structure was confirmed using ¹H-NMR analysis.

### Example MS2 TFSCH₂NB

Norbornene ethylamine (NBCH₂CH₂NH₂) was obtained by first reacting 5-norbornene-2-carboxaldehyde (NBC(O)H) with nitromethane in the presence of sodium hydroxide in methanol followed by selective reduction of the nitroethyl pendent group with lithium aluminum hydride. This synthesis had being reported by Kas'yan et al, in Russ. J. Org. Chem. 2002, 38(1), 29-35. Norbornene ethylamine was reacted with trifluoromethane sulfonic anhydride in the presence of triethylamine to form the target monomer, TFSCH₂NB.

### Examples MS3 NBXOCH₃ and MS4 NBCH₂OC₃H₇

A 60% dispersion of sodium hydride in the quantity shown in Table A was mixed with anhydrous THF (150 mL) and cooled in an ice bath. X as shown in Table A, was added slowly (30 minutes) to the stirred suspension under a nitrogen atmosphere.

| **Table A** | **MS3** | **MS4** |
|---|---|---|
| sodium hydride | 8.8g,0.220mol | 13.2 g, 0.330 mol |
| X | NBXOH 30.0 g, 0.197 mol | NBCH₂OH 30.0 g, 0.242 mol (in 25 mL THF) |
| Y | 2 | 1 |
| Z | methyl iodide 70.0 g, 0.493 mol | 1-bromopropane 59.0 g, 0.479 mol |
| heating time (hours) | 1 | 20 |
| solvent | Chloroform 150 mL | Hexanes 200 g |
| water | 100 g | 200 g |
| 10% sulfuric acid | 2x100g | 2x100g |
| water | 3x100g | 2 x 200 g |
| yield | 85% | 63% |

The mixture was refluxed at 60-65 C for Y hour(s), Z was added and the heating continued for the number of hours shown in Table A. The reaction mixture was filtered. The solvent shown in Table A was added to the filtrate and washed with water, 10% sulfuric acid and water again as shown in Table A. The organic layer dried over anhydrous magnesium sulfate and concentrated. The reduced pressure distillation of the crude product yielded the % of the target compound shown in Table A.

### Example MS5 NBHFAEsNB

Trifluoroacetic acid (117 g, 1.02 mol) was added to a solution of HFANB (140 g, 0.511 mol) in toluene (240 mL). The mixture was then stirred for 20 hours under nitrogen atmosphere at room temperature, after which it was diluted with excess toluene and the toluene solution washed with water (250 mL) and a brine solution (300 mL). The organic phase was dried with anhydrous magnesium sulfate, filtered and concentrated. Crude product was purified by reduced pressure distillation to obtain 175 g of the intermediate HFANBOCOCF₃.

The HFANBOCOCF₃ (175 g, 0.450 mol), obtained above, was mixed with water (750 mL), methanol (300 mL) and sodium hydroxide (30 g, 0.75 mol) and then stirred at room temperature for 1.5 hours. Hydrochloric acid solution (10%) was added to bring the pH of the solution to from 1 to 2 and a split into two layers was observed. A first organic layer (lower layer) was removed and the upper aqueous layer washed with toluene (2 x 300 mL) and the toluene layers obtained combined with the first organic layer and these combined layers were then washed with water (300 mL) and 10% sodium chloride (300 mL), separated and dried over anhydrous magnesium sulfate. The toluene was removed to obtain 140 g of crude HFANBOH.

The HFANBOH (50 g, 0.17 mol), obtained from above, was dissolved in 300 mL anhydrous THF and cooled in an ice bath. n-Butyllithium (160 mL of 2.5M solution in hexane, o.4 mol) was added through a rubber septum using a syringe under nitrogen atmosphere. The temperature of the solution was allowed to come to room temperature while stirring for 5 hours. The solution was then cooled to 0-5°C, with stirring, and acrylyl chloride (18.1 g, 0.2 mol) dissolved in 50 mL anhydrous THE was added while stirring was continued. After the addition of the acrylyl chloride completed, the solution was allowed to come to the room temperature and the stirring continued overnight. Next, the reaction mixture was acidified to pH about 4 using 5% hydrochloric acid solution. Two layers formed and the organic layer separated, concentrated using a rotary evaporator and then dissolved in diethyl ether (300 mL). The ether solution was washed with water (2 x 200 mL) and brine solution(2 x 200 mL), the dried over anhydrous magnesium sulfate and concentrated. The product (HFANBOCOCHCH₂) was purified by distillation under reduced pressure.

HFANBOCOCHCH₂ (28.0 g, 0.081 mol), obtained from above, was dissolved in 100 g toluene. Cyclopentadiene (16.0 g, 0.24 mol) was added to the solution and stirred under nitrogen atmosphere at room temperature for 16 hours. Toluene was removed rotary evaporation at 50-60°C and the crude product was heated to 40-60°C under vacuum for 1.5-2 hours. The final product, NBHFAEsNB, was purified by column chromatography using silica gel.

The following two examples are in whole or in part, prospective examples directed to monomer synthesis. That is to say, that while some or all of the specific procedures provided below was not yet performed, the inventors believe that the well known chemical process(es) suggested will provide the results indicated.

### Prospective Monomer Synthesis Example

### Example MS1p TFSnPrNB

NBCH₂CH₂CH₂Br is obtained by a Diels-Alder reaction and is converted to NBCH₂CH₂CH₂CN using a known chemical reaction. The nitrile obtained is then chemically reduced with lithium aluminum hydride to form the amide and then treated with trifluoromethane sulfonic anhydride to provide the target compound.

### Example MS2p TFSsecPrNB

Portions of this synthesis were modified from the original literature report: Kas'yan, et al. in Russian Journal of Organic Chemistry 2002, 38(1), 29-35. Sodium hydroxide (29.5 g, 0.738 mol) was dissolved in deionized water (75 g) and cooled in an ice bath. Norbornene carboxaldehyde (50.0 g, 0.410 mol), nitroethane (32.3 g, 0.431 mol) and methanol (300 mL) placed in a 1L 3-neck round bottomed flask and cooled in an ice water/salt bath to about -5 C to -10 °C). The cold sodium hydroxide solution was added to this flask drop wise while keeping the temperature below -5°C. The solution was brought to room temperature in 2 hours and the stirring continued for 15 hours at room temperature. The white solid mass formed was partially dissolved in cold water (500 mL). This suspension was added to 20% hydrochloric acid solution (600 mL) and extracted with methylene chloride (2 x 300 mL). The methylene chloride extract was washed with brine solution (2 x 250 mL), dried over anhydrous magnesium sulfate, filtered and concentrated. The reduced pressure distillation of the crude product yielded the target compound (NBCH=C(CH₃)NO₂) in 47% yield.

It is believed that the nitro compound (NBCH=C(CH₃)NO₂) will be selectively reduced by lithium aluminum hydride to form the corresponding amine, NBCH₂CH(CH₃)NH₂. Further, it is believed that this amine will be further derivatized to the sulfonamide product (TFSsecPrNB) by reaction with trifluoromethane sulfonic chloride or trifluoromethane sulfonic anhydride in the presence of a triethylamine base.

### Examples P3

### Polymers of TFSNB and C8AcNB

The variables for these examples are shown in Table B. To a glass reactor equipped with stirring, TFSNB toluene; ethyl acetate; and C8AcNB; were added. The mixture was sparged and placed in the dry box where solid DANFABA and triethylsilane were added. The reactor was taken out of the dry box and sparged glacial acetic acid, was added. The mixture was then heated to 100 °C after which Pd-1206 in ethyl acetate was added. The mixture was maintained at 100 °C with stirring for the length of time indicated and then allowed to cool to room temperature. The amount of total solids indicated that essentially 100% conversion of monomers had occurred. Each reaction mixture was purified to remove residual monomer and catalyst. The analytical data obtained is shown in the table below.

| **Table B** | P3 |
|---|---|
| TFSNB | 356.2 g |
| | 1.397 mol |
| C8AcNB | 128.7 g |
| | 0.248 mol |
| toluene | 529.6 g |
| ethyl acetate | 79 g |
| DANFABA | 3.96 g |
| | 4.95x10⁻³ mol |
| triethylsilane | 13.4 g |
| | 0.116 mol |
| glacial acetic acid | 1.98 g |
| | 0.0330 mol |
| Pd-1206 | 1.99 g |
| | 1.65 x 10⁻³ mol |
| ethyl acetate | 97.5 |
| hours | 18 |
| M_{w} | 5020 |
| Mₙ | 3440 |
| PDI | 1.46 |
| Molar Ratio | 90:10 |
| CA | 93° |
| SA | 18° |
| RA | 74° |
| Dissolution Rate | 600 nm/sec |
| OD | 0.16 µ⁻¹ |

### Example P10

### Polymers of TFSNB and C8AcNB

The variables for example P10 are shown in Table E. TFSNB, toluene, ethyl acetate and one of C8AcNB or secPrHFAEsNB were added to a glass reactor with stirring and the mixture sparged, after which the reactor was placed in a dry box. In the dry box; triethylsilane; Pd-1206; and DANFABA were added with stirring, the reactor capped and brought out the dry box. Sparged glacial acetic acid was added and the mixture heated to 100°C for the length of time indicated in the table then allowed to cool to room temperature. The reaction mixture was added into hexane to cause precipitation and the polymer was collected dried under vacuum at 90°C. The analytical data obtained is shown in the table.

| **Table E** | **P10** |
|---|---|
| TFSNB | 147.5 g |
| | 0.578 mol |
| C8AcNB, | 53 g |
| | 0.102 mol |
| Triethylsilane | 5.54 g |
| | 0.0476 mol |
| Toluene | 225 g |
| ethyl acetate | 75 g |
| DANFABA | 0.817 g |
| | 1.02 x 10⁻³ mol |
| Pd-1206 | 0.410 g 3.4x10⁻⁴ mol |
| glacial acetic acid | 0.817 g 0.0136 mol |
| Hours | 18 |
| M_{w} | 6975 |
| Mₙ | 4450 |
| PDI | 1.57 |
| Molar Ratio | 92:8 |
| CA | 89° |
| SA | 28° |
| OD | 0.10 µ⁻¹ |

### Examples P13 and P14

### Polymers of TFSNB and C9BrAcNB or C10BrAcNB

The variables for examples P13, and P 14 are shown in Table F. A glass reactor equipped with stirring was placed in a dry box and TFSNB, toluene, ethyl acetate and one of C9BrAcNB or C10BrAcNB were added.
For each of P12, P13 and P14, DANFABA, Pd-1206 and triethylsilane were added to the reactor, the reactor sealed and removed from the dry box. Sparged glacial acetic acid was then added and the mixture heated to 100°C, with stirring, for the length of time shown in the table after which it was allowed to cool to room temperature. The reaction mixture was purified to remove residual monomer and catalyst. For P 13 the reaction mixture was added to heptane and in P 14 to hexane, the resulting precipitate collected and dried. The analytical data obtained is shown in the table.

| **Table** F | **P13** | **P14** |
|---|---|---|
| TFSNB | 51.1g | 45.0 g |
| | 0.200 mol | 0.176 mol |
| C9BrAcNB or C10BrAcNB | 28.5 g | 27.3 g |
| | 0.0500 mol | 0.0440 mol |
| triethylsilane | 2.04 g | 1.93 g |
| | 0.0175 mol | 0.0166 mol |
| Toluene | 89.5 g | 80 g |
| ethyl acetate | 29.8 g | 27 g |
| DANFABA | 0.601 g | 0.529 g |
| | 7.50 x 10⁻⁴ mol | 6.61 x 10-⁴ mol |
| Pd-1206 | 0.302 g | 0.265 g |
| | 2.50 x 10⁻⁴ mol | 2.20 x10⁻⁴ mol |
| glacial acetic acid | 0.30 g | 0.26 g |
| | 5.0 x 10⁻³ mol | 4.4 x 10⁻³ mol |
| Hours | 20 | 22 |
| Yield | 37 g 47% | 36.4 g 50% |
| M_{w} | 5060 | 5110 |
| Mₙ | 3660 | 3760 |
| PDI | 1.38 | 1.36 |
| Molar Ratio | 79:21 | 87:13 |
| CA | 89° | 89° |
| SA | 22° | 25° |
| OD | 0.17µ⁻¹ | 0.13µ⁻¹ |

### Examples P15; P16

### Polymers of TFSNB and C8GAcNBr or C10GAcNB

The variables for examples P15, P16 are shown in Table G. In the dry box; TFSNB; triethylsilane; toluene; ethyl acetate; Pd-1206; DANFABA and one of C8GAcNB, C10GAcNB were added to a glass reactor equipped with stirring. The reactor was capped and brought out the dry box. Glacial acetic acid, sparged with nitrogen, was added and the mixture heated to 100 °C for the length of time shown in table, after which it was allowed to cool to room temperature. After purification to remove residual monomer and catalyst, the reaction mixture was added into heptane to cause precipitation, the precipitate collected and dried under vacuum at 90 °C. The analytical data obtained is shown in the table. It should be noted that during the purification and isolation of the P15 and P16 polymers some amount of 5-norbornene-2-methanol is formed from the corresponding norbornene acetate These amounts are presented as the last number in the molar ratios shown in the table below.

| **Table G** | **P15** | **P16** |
|---|---|---|
| TFSNB | 81.7 g | 47.0 g |
| | 0.320 mol | 0.184 mol |
| C8AcNB, C10BrAcNB | 44.2 g | 30.7 g |
| | 0.0800 mol | 0.0460 mol |
| triethylsilane | 3.26 g | 1.87g |
| | 0.0280 mol | 0.0161 mol |
| Toluene | 142 g | 87.4 g |
| ethyl acetate | 47.2 g | 29.1 g |
| DANFABA | 0.481 g | 0.553 g |
| | 6.01 x 10⁻⁴ mol | 6.90 x 10⁻⁴ mol |
| Pd-1206 | 0.241 g | 0.277 g |
| | 2.00 x 10⁻⁴ mol | 2.30 x 10⁻⁴ mol |
| glacial acetic acid | 0.48 g | 0.276 g |
| | 8.0x10⁻³ mol | 4.6 x 10⁻³ mol |
| Hours | 19 | 20 |
| Yield | 50 g 40% | 27 g 35% |
| M_{w} | 5150 | 5180 |
| Mₙ | 3740 | 3860 |
| PDI | 1.38 | 1.34 |
| Molar Ratio | 84:4:12 | 87:3:10 |
| CA | 90° | 85° |
| SA | 24° | 26° |
| OD | 0.08 µ¹⁻ | 0.10 µ⁻¹ |

### Lithographic Behavior of TFSNB copolymers as a Top-Coat Layers

### Examples TC-5 d-f

The copolymers of TFSNB indicated in Table S were evaluated to determine contact angle (CA), sliding angle (SA), dissolution rate (DR) in aqueous alkali developer and waterproofness (WP) using the methods of previously described measurement set 2. As the data presented indicates, films formed from such samples exhibited contact and sliding angles, waterproofness and dissolution rates that are indicate such materials as being acceptable for use as protective films (top-coats) in an immersion lithographic process. In addition, the evaluation of such films with regard to scanability, also produced acceptable results.

Further to the evaluation of the above copolymers, a first set of coated silicon wafers were prepared by applying the following film forming materials to the wafer by a spin coating method. For each wafer, first an organic antireflection film composition "ARC29" (by Brewer Science, Inc.) was applied to the wafer, and baked and dried on a hot plate at 225°C for 60 seconds to form an antireflection film having a thickness of about 77 nm. Next a positive photoresist composition "TARF-P6111ME" (by Tokyo Ohka Kogyo Co., Ltd.) was applied onto the antireflection film, and pre-baked and dried on a hot plate at 130°C for 90 seconds to form a photoresist film having a thickness of about 225 nm. Then, a composition of each of the copolymers from Table S was applied onto one of the coated wafers, over the photoresist film, and heated at 90°C for 60 seconds to form a protective film or top-coat layer having a thickness of about 140 nm, thereover.

Next, using a "NSR S302A" (by Nikon Corp.) lithographic tool having a 193 nm ArF excimer laser source, each of the coated wafers was subjected to ordinary dry exposure through a mask pattern. After the exposure, pure water at 23°C was dropped onto the protective film for 1 minute while the substrate was kept rotating on a spinner chuck to simulate an immersion lithography environment. After the addition of pure water thereto, the substrate was subjected to PEB treatment at 130°C for 90 seconds, and then subjected to an alkali developer (aqueous 0.26N TMAH solution) at 23°C for 60 seconds during a pattern development process. As a result of this development process, the top-coat layer was completely removed, and a well developed pattern formed in the resist film. Such pattern, a line-and-space (1:1) resist pattern having a pitch of 130 nm, was observed with a scanning electronic microscope (SEM), and its pattern profile had a good rectangular form.

Continuing the evaluation of the copolymers of Table S, a second set of coated silicon wafers was prepared as described above for the first set. However, the second set of wafers was subj ected to exposure using a laboratory kit for liquid immersion lithography (LEIES 193-1, by Nikon Corp.), where the LEIES was set for two-beam interference exposure of each wafer using a 193 nm ArF excimer laser source..

After exposure, each of the wafers was subjected to the development process used for the first set. This development process completely removed the top-coat layer to reveal a well developed pattern formed in the resist film. Such pattern, the line-and-space (1:1) resist pattern having a pitch of 130 nm used for the first set of wafers, was observed with an SEM and found to have a good pattern profile with a good rectangular form.

It should be realized that by and through the examples, data and discussion thereof has been provided that demonstrate that embodiments of top coat polymers, top coat (protective film-forming) materials formed using such polymers, top coat layers formed thereof and processes for using such layers provide solutions to the aforementioned problems found with previously known materials. Such top coat materials and layers formed thereof provide alkali solubility, resistance to an immersion fluid, low solubility to and with photoresist layer components, good protection against leaching from and/or to such photoresist layer and good protection as gas-barrier layer and low optical densities. In addition, top coat materials and layers formed thereof provide, during an immersion lithographic process, excellent scanability and reduced defectivity as compared to a process where such a top coat layer is not used. Further, such layers demonstrate high contact and receding angles and a low sliding angle which are believed desirable for such performance. Also, it should be realized that the examples provided herein are not limiting, but rather exemplary of what might be obtained through a process of polymer design.

## Claims

1. A non-self imageable polymer consisting of norbornene-type repeating units, said polymer comprising a first norbornene-type repeating unit represented by Formula **I:** 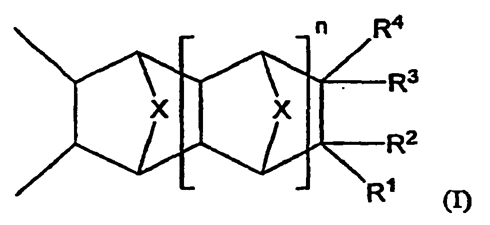 where X is -CH₂-, -CH₂CH₂, O or S; n is an integer from 0 to 5 inclusive; each of R¹ to R⁴ independently represents hydrogen, a linear or branched alkyl group, or a linear or branched haloalkyl group, subject to the proviso that at least one of R¹ to R⁴ is a - QNHSO₂R⁵ group where Q is a linear or branched alkyl spacer of 1 to 5 carbon atoms, and R⁵ is a perhalo group of 1 to 10 carbon atoms, and a second norbornene-type repeating unit represented by Formula IV: 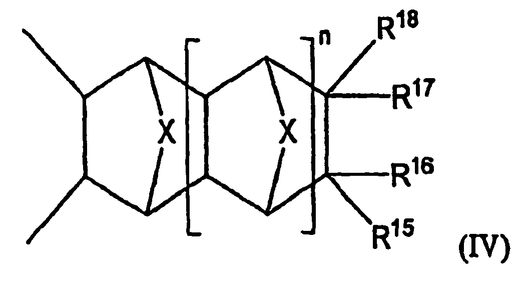 where X and n are as defined for Formula I and each of R¹⁵ to R¹⁸ independently represents hydrogen, a linear or branched alkyl group, or a linear or branched haloalkyl group, subject to the proviso that at least one of R¹⁵ to R¹⁸ is one of groups D, E or F: 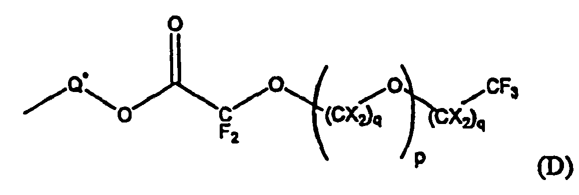 or 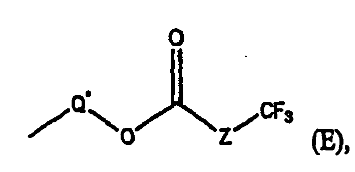 or 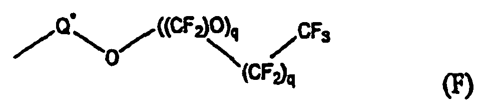 where each X is Independently either F or H, each q is independently an integer from 1 to 3, p is an integer from 1 to 5, Q* is a linear or branched alkyl spacer of 1 to 5 carbon atoms, and Z is a linear or branched halo or perhalo spacer of 2 to 10 carbon atoms.

2. The non-self imageable polymer of Claim 1 further comprising a third type of norbornene-type repeating unit represented by Formula II: 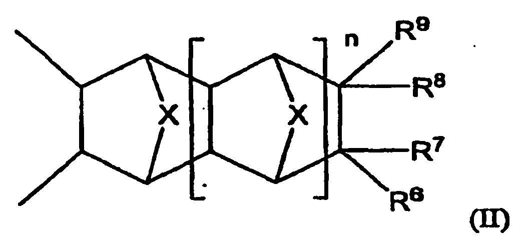 where X and n are as defined for Formula I and each of R⁶ to R⁹ independently represents hydrogen, a linear or branched alkyl group, or a linear or branched haloalkyl group, subject to the proviso that at least one of R⁶ to R⁹ is - Q^{‡}(CO)O- (CH₂)ₘ-R¹⁰ where Q^{‡} is an optional, linear or branched alkyl spacer where if present is of 1 to 5 carbon atoms, m is either 0 or an integer from 1 to 3 inclusive; and R¹⁰ is a linear or branched perhalo alkyl of 1 to 10 carbon atoms.

3. The non-self imageable polymer of Claim 2 where R⁵ is CF₃ and R¹⁰ is C₂F₅, preferably where Q is Independently CH₂ or CH₂CH₂.

4. The non-self imageable polymer of Claims 2 or 3 having a molar ratio of first repeating units to third repeating units of from 99:1 to 60:40, preferably from 95:5 to 75:25.

5. The non-self imageable polymer of Claims 2 or 3 having a molecular weight (Mw) of from 2000 to 10000, preferably from 4000 to 7000.

6. The non-self imageable polymer of Claim 2 having a molecular weight (Mw) of from 4000 to 6000, a polydispersity of less than 2, a molar ratio of first repeating units to third repeating units of from 85:15 to 75:25 and where R⁵ is CF₃, R¹⁰ is C₂F₅, Q is CH₂ and Q^{‡} is not present.

7. The non-self imageable polymer of Claims 1 or 2 further comprising a fourth type of norbornene-type repeating unit represented by Formula III: 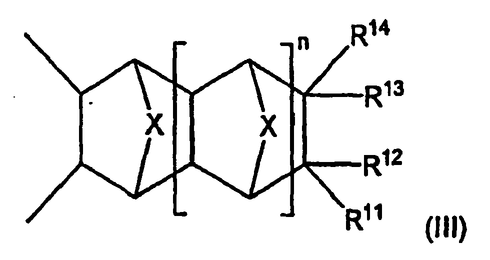 where X and n are as defined for Formula I and each of R¹¹ to R¹⁴ independently represents hydrogen, a linear or branched alkyl group, or- a linear or branched haloalkyl group, subject to the proviso that at least one of R¹¹ to R¹⁴ is one of groups A, B or C: 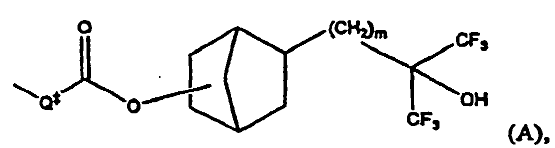 or 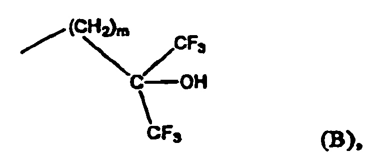 or 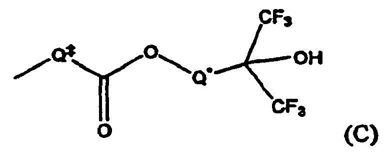 where m is an integer from 1 to 3 inclusive and Q^{‡} is as defined in Claim 2 and Q* is a linear or branched alkyl spacer of 1 to 5 carbon atoms.

8. The non-self imageable polymer of Claim 7 comprising from 40 to 98 mole percent (mol%) of the first type of repeating unit, and independently, if present, from 1 to 30 mol% of the third type of repeating unit, and from 1 to 40 mol% of the fourth type of repeating unit and the repeating unit of formula (IV), preferably comprising from 50 to 80 mol% of the first type of repeating unit, and independently, if present, from 10 to 25 mol% of the third type of repeating unit, and from 5 to 30 mol% of the fourth type of repeating unit and the repeating unit of Formula (IV).

9. The non-self imageable polymer of any of Claims 1, 2, or 7, further comprising a 5 substituted linear or branched alkyl norbornene repeating unit or a 5 substituted linear or branched alkyl ester norbornene, preferably where the 5 substituted linear or branched alkyl norbornene repeating unit or the 5 substituted alkyl ester repeating unit is a hexyl or butyl 5 substituted norbornene repeating unit or a 5 substituted isobornyl ester norbornene.

10. The non-self imageable polymer of Claims 8 or 9 having a molecular weight (Mw) of from 2000 to 10000, preferably from 3500 to 7000.

11. The non-self imageable polymer of Claim 2, comprising from 60 to 85 mol% of the first repeating unit, 15 to 40 mol% of the third repeating unit, and where for each repeat unit n is 0, R⁵ is CF₃, R¹⁰ is C₂F₅, Q is CH₂, m is 1 and Q^{‡} is not present.

12. The non-self imageable polymer of Claim 11, comprising from 75 to 85 mol% of the first repeating unit, 15 to 25 mol% of the third repeating unit and a molecular weight (Mw) of from 3000 to 6000 with a polydispersity of 2 or less.

13. A method for making a non-self imageable polymer consisting of norbornene-type repeating units comprising: charging a reaction vessel with a first norbornene-type monomer represented by Formula IA: 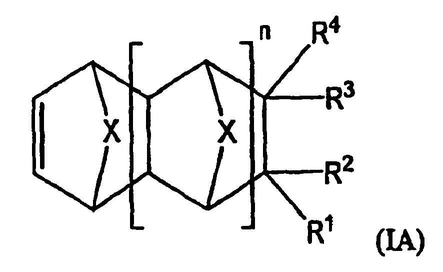 where X is -CH₂-, -CH₂CH₂-, O or S; n is an integer from 0 to 5 inclusive; each of R¹ to R⁴ independently represents hydrogen, a linear or branched alkyl group, or a linear or branched haloalkyl group, subject to the proviso that at least one of R¹ to R⁴ is a - QNHSO₂R⁵ group where Q is a linear or branched alkyl spacer of 1 to 5 carbon atoms, and R⁵ is a perhalo group of 1 to 10 carbon atoms, and a norbornene-type monomer represented by Formula IVA 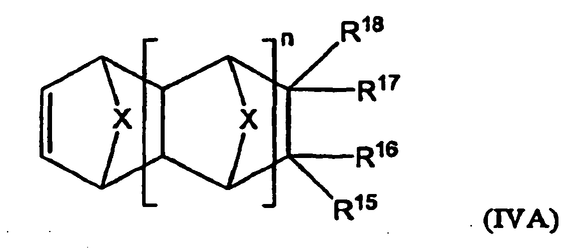 where X and n are as defined for Formula I and each of R¹⁵ to R¹⁸ independently represents hydrogen, a linear or branched alkyl group, or a linear or branched haloalkyl group, subject to the proviso that at least one of _{R}¹⁵ to R¹⁸ is one of groups D, E or F: 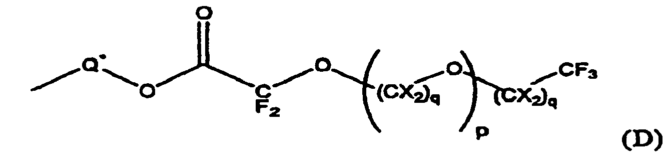 or 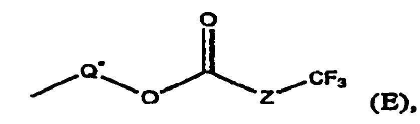 or 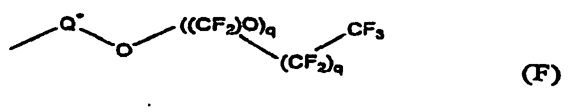 where each X is independently either F or H, each q is Independently an integer from 1 to 3, p is an integer from 1 to 5, Q* is a linear or branched alkyl spacer of 1 to 5 carbon atoms, and Z is a linear or branched halo or perhalo spacer of 2 to 10 carbon atoms,
optionally charging the reaction vessel with one or more other norbornene- type monomers, said other monomers being structurally distinct from the first monomer;
further charging the reaction vessel with an appropriate solvent, a catalyst and an optional cocatalyst;
providing agitation to the reaction vessel contents to cause the first monomer, any optional other monomers, catalyst and optional cocatalyst to dissolve in the solvent; and
providing heat and continued agitation to the contents for a time sufficient to cause polymerization of the first monomer and the monomer of Formula IVA and any other monomers present therein.

14. The method of Claim 13 where optionally charging the reaction vessel comprises charging the reaction vessel with a norbornene-type monomer represented by Formula IIA: 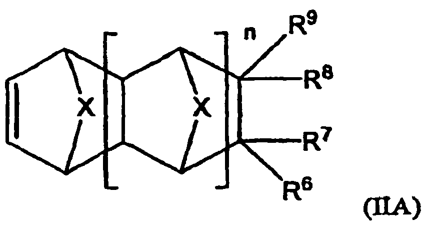 where X and n are as defined for Formula I and each of R⁶ to R⁹ independently represents hydrogen, a linear or branched alkyl group, or a linear or branched haloalkyl group, subject to the proviso that at least one of R⁶ to R⁹ is -Q^{‡} (CO)O-(CH₂)ₘ-R¹⁰ where Q^{‡} is an optional, linear or branched alkyl spacer where if present is of 1 to 5 carbon atoms, m is either 0 or an integer from 1 to 3 inclusive; and R¹⁰ is a linear or branched perhalo alkyl of 1 to 10 carbon atoms;

15. The method of Claim 13 where optionally charging the reaction vessel comprises charging the reaction vessel with a norbornene-type monomer represented by Formula IIA and one or more norbornene-type monomers represented by Formulae IIIA : 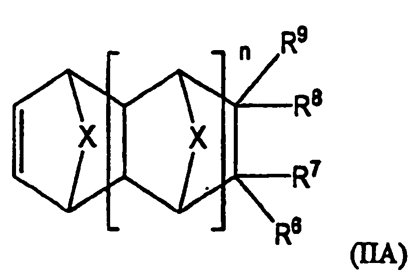 where X and n are as defined for Formula IA and each of R⁶ to R⁹ independently represents hydrogen, a linear or branched alkyl group, or a linear or branched haloalkyl group, subject to the proviso that at least one of R⁶ to R⁹ is - Qt (CO)O-(CH₂)ₘ-R¹¹where Q^{‡} is an optional, linear or branched alkyl spacer where if present is of 1 to 5 carbon atoms, m is either 0 or an integer from 1 to 3 inclusive; and R¹⁰ is a linear or branched perhalo alkyl of 1 to 10 carbon atoms; 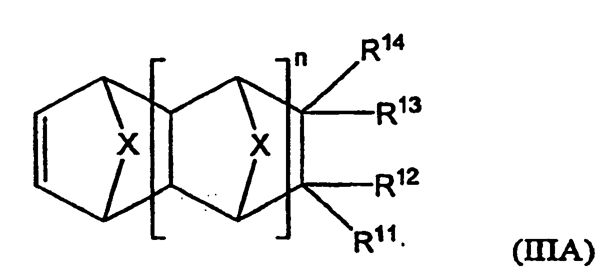 where X and n are as defined for Formula IA and each of R¹¹ to R¹⁴ independently represents hydrogen, a linear or branched alkyl group, or a linear or branched haloalkyl group, subject to the proviso that at least one of R¹¹ to R¹⁴ is one of groups A, B or C: 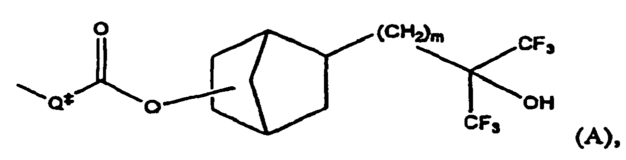 or 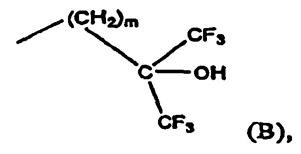 or 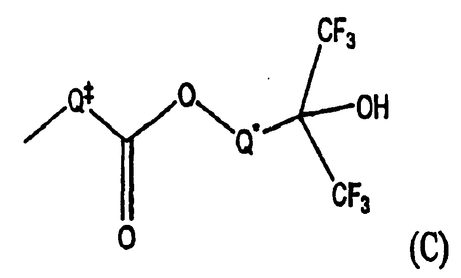 where m is an integer from 1 to 3 inclusive and Q^{‡} is as defined above and Q* is a linear or branched alkyl spacer of 1 to 5 carbon atoms.

16. The method of Claim 15 where the optionally charged one or more norbornene-type monomers represented by Formulae IIIA further include 5 substituted linear or branched alkyl norbornene-type monomers and 5 substituted linear or branched alkyl ester norbornene-type monomers.

17. The method of any of Claims 13, 14, 15 or 16 where further charging the reaction vessel comprises charging the reaction vessel with:
a solvent selected from the group benzene, toluene, xylene, hexane, heptane, cyclohexane, dichloromethane, ethylchloride, tetrahydrofuran, ethyl acetate and mixtures thereof;
an optional cocatalyst selected from lithium tetrakis(pentafluorophenyl)borate diethyl etherate (LiFABA) and N-dimethylanilinium tetrakis-(pentafluorophenyl)borate (DANFABA); and
a catalyst selected from (Acetonitrile) bis(triisopropylphosphine)palladium(acetate) tetrakis (pentafluorophenyl)borate (Pd 1206) and (Acetonitrile) bis(tricyclohexyl-t-butylphosphine)palladium(acetate) tetrakis (pentafluorophenyl)borate (Pd 1394).

18. The method of Claim 13 where providing heat comprises heating the contents of the reaction vessel to a temperature selected from a range of from 60°C to 100°C and maintaining the contents at that temperature for the lesser of 24 hours or the completion of the polymerization reaction.

## Patentansprüche

1. Nichtselbstbeschriftbares Polymer, das aus Repetiereinheiten des Norbornen-Typs besteht, wobei das Polymer Folgendes umfasst: eine erste Repetiereinheit des Norbornen-Typs, die durch Formel I dargestellt wird: 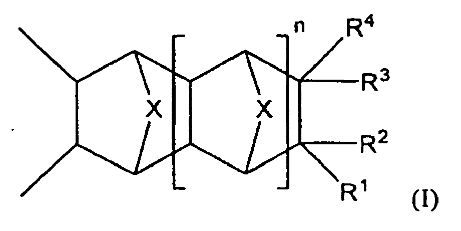 wobei X = -CH₂-, -CH₂CH₂-, O oder S ist, n eine ganze Zahl von 0 bis 5 einschließlich ist, R¹ bis R⁴ jeweils unabhängig für Wasserstoff, eine lineare oder verzweigte Alkylgruppe oder eine lineare oder verzweigte Halogenalkylgruppe stehen, mit der Maßgabe, dass wenigstens einer der Reste R¹ bis R⁴ eine Gruppe -QNHSO₂R⁵ ist, wobei Q eine lineare oder verzweigte Alkylspacergruppe mit 1 bis 5 Kohlenstoffatomen ist und R⁵ eine perhalogenierte Gruppe mit 1 bis 10 Kohlenstoffatomen ist; und eine zweite Repetiereinheit des Norbornen-Typs, die durch Formel IV dargestellt wird: 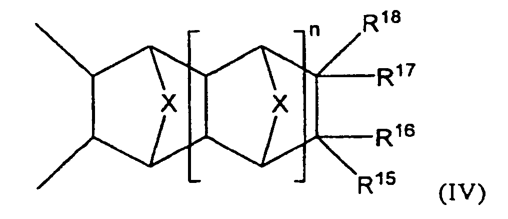 wobei X und n wie für Formel I definiert sind und R¹⁵ bis R¹⁸ jeweils unabhängig für Wasserstoff, eine lineare oder verzweigte Alkylgruppe oder eine lineare oder verzweigte Halogenalkylgruppe stehen, mit der Maßgabe, dass es sich bei wenigstens einem der Reste R¹⁵ bis R¹⁸ um eine der Gruppen D, E oder F handelt: 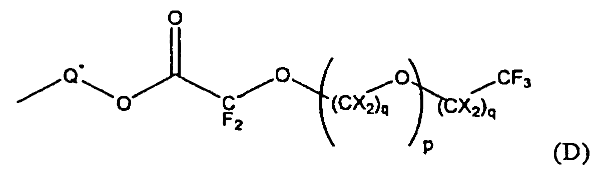 oder 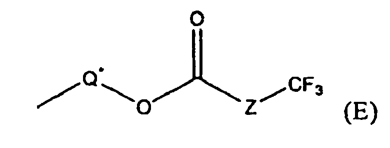 oder 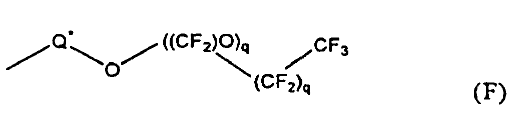 wobei X jeweils unabhängig entweder F oder H ist, q jeweils unabhängig eine ganze Zahl von 1 bis 3 ist, p eine ganze Zahl von 1 bis 5 ist, Q* eine lineare oder verzweigte Alkylspacergruppe mit 1 bis 5 Kohlenstoffatomen ist und Z eine lineare oder verzweigte Halogen- oder Perhalogen-Spacergruppe mit 2 bis 10 Kohlenstoffatomen ist.

2. Nichtselbstbeschriftbares Polymer gemäß Anspruch 1, das weiterhin einen dritten Typ von Repetiereinheit des Norbornen-Typs umfasst, der durch Formel II dargestellt wird: 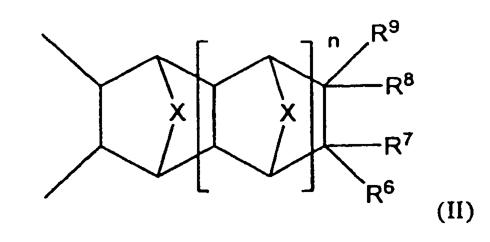 wobei X und n wie für Formel I definiert sind und R⁶ bis R⁹ jeweils unabhängig für Wasserstoff, eine lineare oder verzweigte Alkylgruppe oder eine lineare oder verzweigte Halogenalkylgruppe stehen, mit der Maßgabe, dass wenigstens einer der Reste R⁶ bis R⁹ = -Q^{‡}(CO)O-(CH₂)ₘ-R¹⁰ ist, wobei Q^{‡} eine fakultative lineare oder verzweigte Alkylspacergruppe mit, falls vorhanden, 1 bis 5 Kohlenstoffatomen ist, m entweder 0 oder eine ganze Zahl von 1 bis 3 einschließlich ist und R¹⁰ eine lineare oder verzweigte perhalogenierte Alkylgruppe mit 1 bis 10 Kohlenstoffatomen ist.

3. Nichtselbstbeschriftbares Polymer gemäß Anspruch 2, wobei R⁵ = CF₃ ist und R¹⁰ = C₂F₅ ist, wobei Q unabhängig CH₂ oder CH₂CH₂ ist.

4. Nichtselbstbeschriftbares Polymer gemäß Anspruch 2 oder 3, das ein Stoffmengenverhältnis von ersten Repetiereinheiten zu dritten Repetiereinheiten von 99:1 bis 60:40, vorzugsweise 95:5 bis 75:25, aufweist.

5. Nichtselbstbeschriftbares Polymer gemäß Anspruch 2 oder 3, das ein Molekulargewicht (Mw) von 2000 bis 10 000, vorzugsweise 4000 bis 7000, aufweist.

6. Nichtselbstbeschriftbares Polymer gemäß Anspruch 2, das ein Molekulargewicht (Mw) von 4000 bis 6000, eine Polydispersität von weniger als 2, ein Stoffmengenverhältnis von ersten Repetiereinheiten zu dritten Repetiereinheiten von 85:15 bis 75:25 aufweist, wobei R⁵ = CF₃ ist, R¹⁰ = C₂F₅ ist, Q = CH₂ ist und Q^{‡} nicht vorhanden ist.

7. Nichtselbstbeschriftbares Polymer gemäß Anspruch 1 oder 2, das weiterhin einen vierten Typ von Repetiereinheit des Norbornen-Typs umfasst, der durch Formel III dargestellt wird: 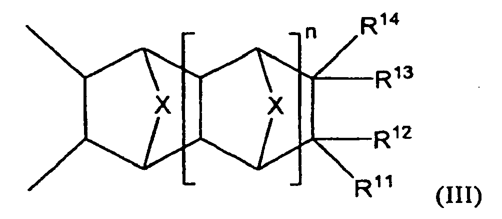 wobei X und n wie für Formel I definiert sind und R¹¹ bis R¹⁴ jeweils unabhängig für Wasserstoff, eine lineare oder verzweigte Alkylgruppe oder eine lineare oder verzweigte Halogenalkylgruppe stehen, mit der Maßgabe, dass es sich bei wenigstens einem der Reste R¹¹ bis R¹⁴ um eine der Gruppen A, B oder C handelt: 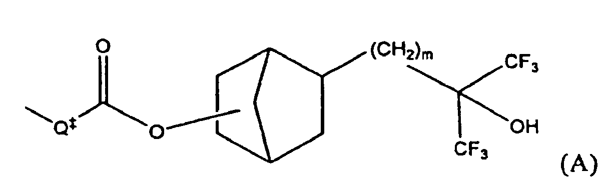 oder 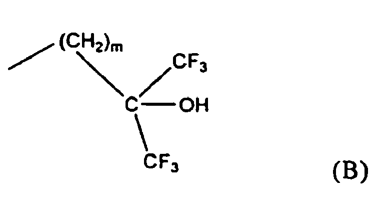 oder 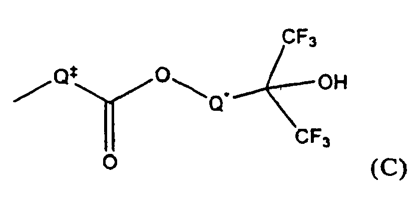 wobei m eine ganze Zahl von 1 bis 3 einschließlich ist und Q wie in Anspruch 2 definiert ist und Q* eine lineare oder verzweigte Alkylspacergruppe mit 1 bis 5 Kohlenstoffatomen ist.

8. Nichtselbstbeschriftbares Polymer gemäß Anspruch 7, das 40 bis 98 Molprozent (Mol-%) des ersten Typs von Repetiereinheit und unabhängig davon, falls vorhanden, 1 bis 30 Mol-% des dritten Typs von Repetiereinheit und 1 bis 40 Mol-% des vierten Typs von Repetiereinheit und der Repetiereinheit von Formel (IV) umfasst, vorzugsweise 50 bis 80 Mol-% des ersten Typs von Repetiereinheit und unabhängig davon, falls vorhanden, 10 bis 25 Mol-% des dritten Typs von Repetiereinheit und 5 bis 30 Mol-% des vierten Typs von Repetiereinheit und der Repetiereinheit von Formel (IV) umfasst.

9. Nichtselbstbeschriftbares Polymer gemäß einem der Ansprüche 1, 2 oder 7, das weiterhin eine 5-substituierte lineare oder verzweigte Alkylnorbornen-Repetiereinheit oder ein 5-substituiertes lineares oder verzweigtes Alkylesternorbornen umfasst, wobei vorzugsweise die 5-substituierte lineare oder verzweigte Alkylnorbornen-Repetiereinheit oder die 5-substituierte Alkylester-Repetiereinheit eine Hexyl- oder Butyl-5-substituierte Norbornen-Repetiereinheit oder ein 5-substituiertes Isobornylesternorbornen ist.

10. Nichtselbstbeschriftbares Polymer gemäß Anspruch 8 oder 9, das ein Molekulargewicht (Mw) von 2000 bis 10 000, vorzugsweise 3500 bis 7000, aufweist.

11. Nichtselbstbeschriftbares Polymer gemäß Anspruch 2, das 60 bis 85 Mol-% der ersten Repetiereinheit und 15 bis 40 Mol-% der dritten Repetiereinheit umfasst, wobei in jeder Repetiereinheit n = 0 ist, R⁵ = CF₃ ist, R¹⁰ = C₂F₅ ist, Q = CH₂ ist, m = 1 ist und Q^{‡} nicht vorhanden ist.

12. Nichtselbstbeschriftbares Polymer gemäß Anspruch 11, das 75 bis 85 Mol-% der ersten Repetiereinheit und 15 bis 25 Mol-% der dritten Repetiereinheit umfasst und ein Molekulargewicht (Mw) von 3000 bis 6000 mit einer Polydispersität von 2 oder weniger aufweist.

13. Verfahren zur Herstellung eines nichtselbstbeschriftbaren Polymers, das aus Repetiereinheiten des Norbornen-Typs besteht, umfassend: das Befüllen eines Reaktionsgefäßes mit einem ersten Monomer des Norbornen-Typs, das durch Formel IA dargestellt wird: 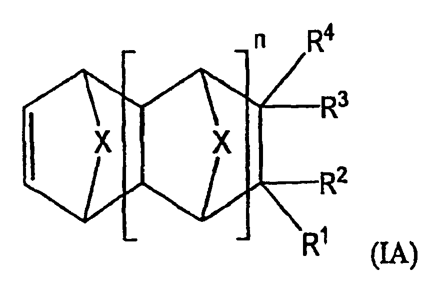 wobei X = -CH₂-, -CH₂CH₂-, O oder S ist, n eine ganze Zahl von 0 bis 5 einschließlich ist, R¹ bis R⁴ jeweils unabhängig für Wasserstoff, eine lineare oder verzweigte Alkylgruppe oder eine lineare oder verzweigte Halogenalkylgruppe stehen, mit der Maßgabe, dass wenigstens einer der Reste R¹ bis R⁴ eine Gruppe -QNHSO₂R₅ ist, wobei Q eine lineare oder verzweigte Alkylspacergruppe mit 1 bis 5 Kohlenstoffatomen ist und R⁵ eine perhalogenierte Gruppe mit 1 bis 10 Kohlenstoffatomen ist; und einem Monomer des Norbornen-Typs, das durch Formel IVA dargestellt wird: 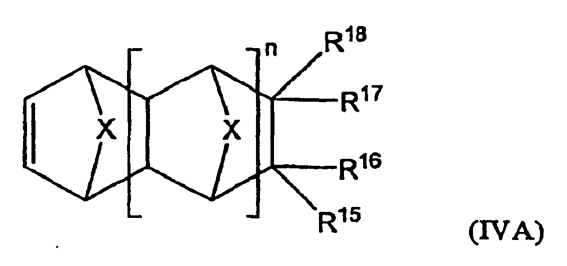 wobei X und n wie für Formel I definiert sind und R¹⁵ bis R¹⁸ jeweils unabhängig für Wasserstoff, eine lineare oder verzweigte Alkylgruppe oder eine lineare oder verzweigte Halogenalkylgruppe stehen, mit der Maßgabe, dass es sich bei wenigstens einem der Reste R¹⁵ bis R¹⁸ um eine der Gruppen D, E oder F handelt: 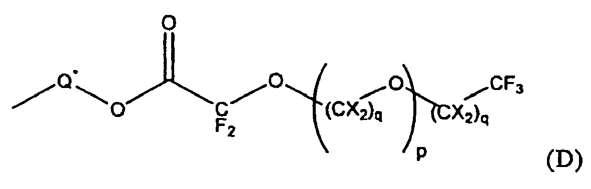 oder 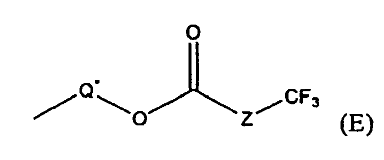 oder 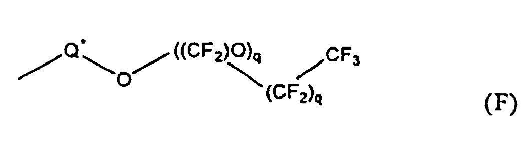 wobei X jeweils unabhängig entweder F oder H ist, q jeweils unabhängig eine ganze Zahl von 1 bis 3 ist, p eine ganze Zahl von 1 bis 5 ist, Q* eine lineare oder verzweigte Alkylspacergruppe mit 1 bis 5 Kohlenstoffatomen ist und Z eine lineare oder verzweigte Halogen- oder Perhalogen-Spacergruppe mit 2 bis 10 Kohlenstoffatomen ist;
gegebenenfalls Befüllen des Reaktionsgefäßes mit einem oder mehreren anderen Monomeren des Norbornen-Typs, wobei die anderen Monomere strukturell verschieden von dem ersten Monomer sind;
weiterhin Befüllen des Reaktionsgefäßes mit einem geeigneten Lösungsmittel, einem Katalysator und gegebenenfalls einem Cokatalysator;
Rühren des Inhalts des Reaktionsgefäßes, so dass bewirkt wird, dass sich das erste Monomer, gegebenenfalls die anderen Monomere, der Katalysator und gegebenenfalls der Cokatalysator in dem Lösungsmittel auflösen; und
Erhitzen und Weiterrühren des Inhalts während einer ausreichenden Zeit, um eine Polymerisation des ersten Monomers und des Monomers der Formel IVA und gegebenenfalls anderer Monomere, die darin vorhanden sind, zu bewirken.

14. Verfahren gemäß Anspruch 13, wobei das gegebenenfalls erfolgende Befüllen des Reaktionsgefäßes das Befüllen des Reaktionsgefäßes mit einem Monomer des Norbornen-Typs umfasst, das durch Formel IIA dargestellt wird: 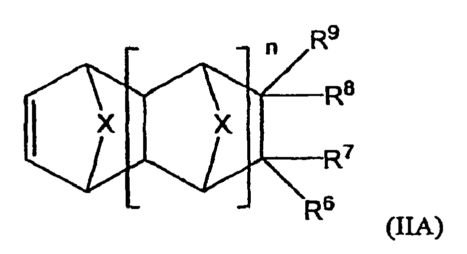 wobei X und n wie für Formel I definiert sind und R⁶ bis R⁹ jeweils unabhängig für Wasserstoff, eine lineare oder verzweigte Alkylgruppe oder eine lineare oder verzweigte Halogenalkylgruppe stehen, mit der Maßgabe, dass wenigstens einer der Reste R⁶ bis R⁹ = -Q^{‡}(CO)O-(CH₂)ₘ-R¹⁰ ist, wobei Q^{‡} eine fakultative lineare oder verzweigte Alkylspacergruppe mit, falls vorhanden, 1 bis 5 Kohlenstoffatomen ist, m entweder 0 oder eine ganze Zahl von 1 bis 3 einschließlich ist und R¹⁰ eine lineare oder verzweigte perhalogenierte Alkylgruppe mit 1 bis 10 Kohlenstoffatomen ist.

15. Verfahren gemäß Anspruch 13, wobei das gegebenenfalls erfolgende Befüllen des Reaktionsgefäßes das Befüllen des Reaktionsgefäßes mit einem Monomer des Norbornen-Typs, das durch Formel IIA dargestellt wird, und einem oder mehreren Monomeren des Norbornen-Typs, die durch Formel IIIA dargestellt werden, umfasst: 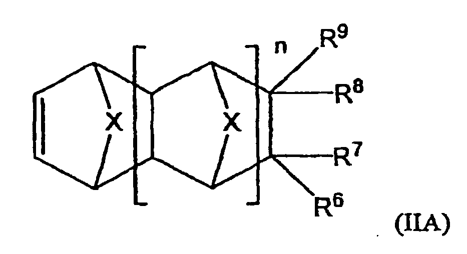 wobei X und n wie für Formel IA definiert sind und R⁶ bis R⁹ jeweils unabhängig für Wasserstoff, eine lineare oder verzweigte Alkylgruppe oder eine lineare oder verzweigte Halogenalkylgruppe stehen, mit der Maßgabe, dass wenigstens einer der Reste R⁶ bis R⁹ = -Q^{‡}(CO)O-(CH₂)ₘ-R¹⁰ ist,
wobei Q^{‡} eine fakultative lineare oder verzweigte Alkylspacergruppe mit, falls vorhanden, 1 bis 5 Kohlenstoffatomen ist, m entweder 0 oder eine ganze Zahl von 1 bis 3 einschließlich ist und R¹⁰ eine lineare oder verzweigte perhalogenierte Alkylgruppe mit 1 bis 10 Kohlenstoffatomen ist; 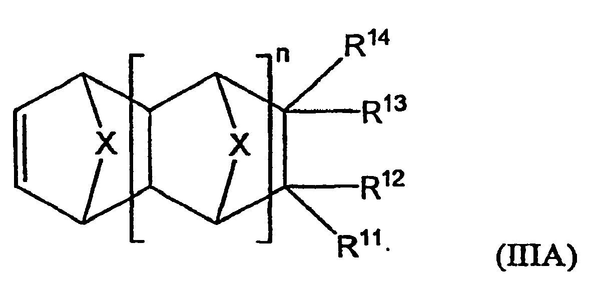 wobei X und n wie für Formel IA definiert sind und R¹¹ bis R¹⁴ jeweils unabhängig für Wasserstoff, eine lineare oder verzweigte Alkylgruppe oder eine lineare oder verzweigte Halogenalkylgruppe stehen, mit der Maßgabe, dass es sich bei wenigstens einem der Reste R¹¹ bis R¹⁴ um eine der Gruppen A, B oder C handelt: 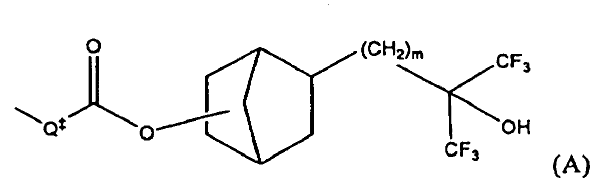 oder 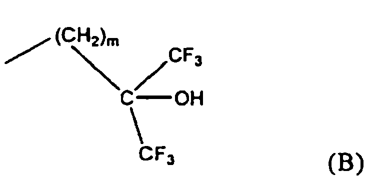 oder 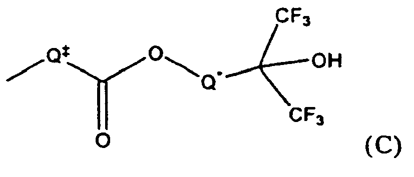 wobei m eine ganze Zahl von 1 bis 3 einschließlich ist und Q^{‡} wie oben definiert ist und Q* eine lineare oder verzweigte Alkylspacergruppe mit 1 bis 5 Kohlenstoffatomen ist.

16. Verfahren gemäß Anspruch 15, wobei die gegebenenfalls eingefüllten ein oder mehreren Monomere des Norbornen-Typs, die durch Formel IIIA dargestellt werden, weiterhin 5-substituierte lineare oder verzweigte Monomere des Alkylnorbornen-Typs und 5-substituierte lineare oder verzweigte Monomere des Alkylesternorbornen-Typs umfassen.

17. Verfahren gemäß einem der Ansprüche 13, 14, 15 oder 16, wobei das weitere Befüllen des Reaktionsgefäßes das Befüllen des Reaktionsgefäßes mit Folgendem umfasst:
einem Lösungsmittel, das aus der Gruppe ausgewählt ist, die aus Benzol, Toluol, Xylol, Hexan, Heptan, Cyclohexan, Dichlormethan, Ethylchlorid, Tetrahydrofuran, Ethylacetat und Gemischen davon besteht;
einem fakultativen Cokatalysator, der aus Lithiumtetrakis(pentafluorphenyl)borat-Diethyletherat (LiFABA) und N-Dimethylaniliniumtetrakis-(pentafluorphenyl)borat (DANFABA) ausgewählt ist; und
einem Katalysator, der aus (Acetonitril)bis(triisopropylphosphin)palladium(acetat)tetrakis(pentafluorphenyl)borat (Pd 1206) und (Acetonitril)bis(tricyclohexyl-t-butylphosphin)palladium(acetat)tetrakis(pentafluorphenyl)borat (Pd 1394) ausgewählt ist.

18. Verfahren gemäß Anspruch 13, wobei das Erhitzen das Erhitzen des Inhalts des Reaktionsgefäßes auf eine Temperatur, die aus einem Bereich von 60 °C bis 100 °C ausgewählt ist, und das Halten des Inhalts auf dieser Temperatur während 24 Stunden oder bis zur Beendigung der Polymerisationsreaktion, je nachdem, was kürzer ist, umfasst.

## Revendications

1. Polymère non auto-imageable constitué de motifs répétés de type norbornène, ledit polymère comprenant un premier motif répété de type norbornène représenté par la formule I : 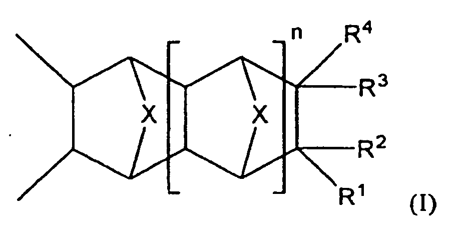 où X est -CH₂-, -CH₂CH₂-, O ou S, n est un nombre entier de 0 à 5 inclus, R¹ à R⁴ représentent chacun indépendamment hydrogène, un groupe alkyle linéaire ou ramifié, ou un groupe haloalkyle linéaire ou ramifié, à condition qu'au moins un parmi R¹ à R⁴ soit un groupe -QNHSO₂R⁵, où Q est un espaceur alkyle linéaire ou ramifié avec 1 à 5 atomes de carbone et R⁵ est un groupe perhalogéné avec 1 à 10 atomes de carbone ; et un deuxième motif répété de type norbornène représenté par la formule IV : 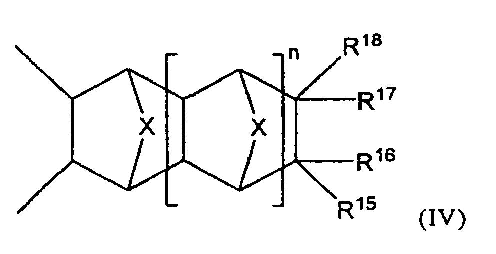 où X et n sont tels que définis pour la formule I et R¹⁵ à R¹⁸ représentent chacun indépendamment hydrogène, un groupe alkyle linéaire ou ramifié, ou un groupe haloalkyle linéaire ou ramifié, à condition qu'au moins un parmi R¹⁵ à R¹⁸ soit un des groupes D, E ou F : 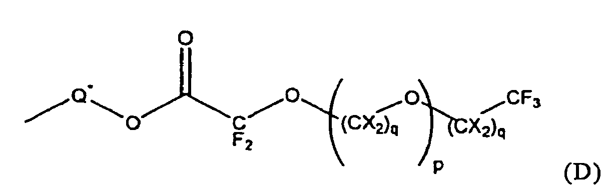 ou 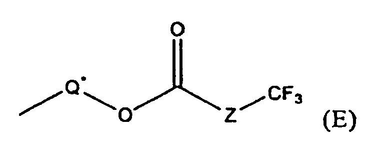 ou 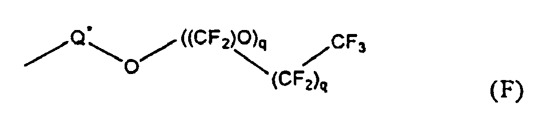 où chaque X est indépendamment soit F soit H, chaque q est indépendamment un nombre entier de 1 à 3, p est un nombre entier de 1 à 5, Q* est un espaceur alkyle linéaire ou ramifié avec 1 à 5 atomes de carbone, et Z est un espaceur halogéné ou perhalogéné, linéaire ou ramifié, avec 2 à 10 atomes de carbone.

2. Polymère non auto-imageable selon la revendication 1, comprenant en outre un troisième motif répété de type norbornène représenté par la formule II : 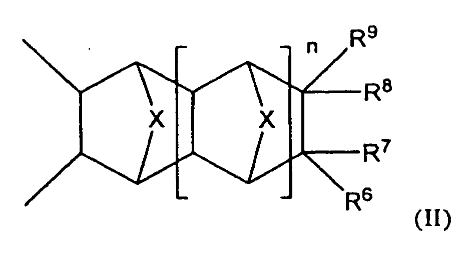 où X et n sont tels que définis pour la formule I, et R⁶ à R⁹ représentent chacun indépendamment hydrogène, un groupe alkyle linéaire ou ramifié, ou un groupe haloalkyle linéaire ou ramifié, à condition qu'au moins un parmi R⁶ à R⁹ soit -Q^{‡}(CO)O-(CH₂)ₘ-R¹⁰, où Q^{‡} est un espaceur alkyle linéaire ou ramifié facultatif avec, le cas échéant, 1 à 5 atomes de carbone, m est soit 0 soit un nombre entier de 1 à 3 inclus et R¹⁰ est un groupe alkyle perhalogéné linéaire ou ramifié avec 1 à 10 atomes de carbone.

3. Polymère non auto-imageable selon la revendication 2, où R⁵ est CF₃ et R¹⁰ est C₂F₅, de préférence où Q est indépendamment CH₂ ou CH₂CH₂.

4. Polymère non auto-imageable selon les revendications 2 ou 3, présentant un rapport molaire de premiers motifs répétés à troisième motifs répétés compris entre 99 : 1 et 60 : 40, de préférence compris entre 95 : 5 et 75 : 25.

5. Polymère non auto-imageable selon les revendications 2 ou 3, présentant un poids moléculaire (Mw) compris entre 2000 et 10000, de préférence compris entre 4000 et 7000.

6. Polymère non auto-imageable selon la revendication 2, présentant un poids moléculaire (Mw) compris entre 4000 et 6000, une polydispersité de moins de 2, un rapport molaire de premiers motifs répétés à troisième motifs répétés compris entre 85 : 15 et 75 : 25, et où R⁵ est CF₃, R¹⁰ est C₂F₅, Q est CH₂ et Q^{‡} n'est pas présent.

7. Polymère non auto-imageable selon les revendications 1 ou 2, comprenant en outre un quatrième type de motif répété de type norbornène représenté par la formule III : 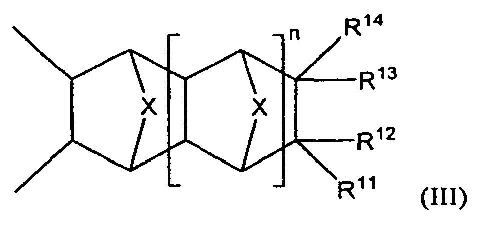 où X et n sont tels que définis pour la formule 1 et R¹¹ à R¹⁴ représentent chacun indépendamment hydrogène, un groupe alkyle linéaire ou ramifié, ou un groupe haloalkyle linéaire ou ramifié, à condition qu'au moins un parmi R¹¹ à R¹⁴ soit un des groupes A, B ou C : 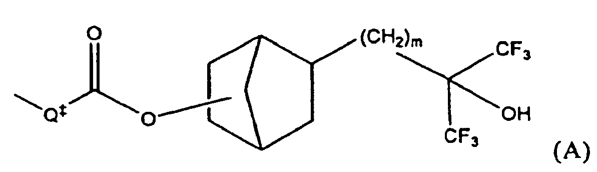 ou 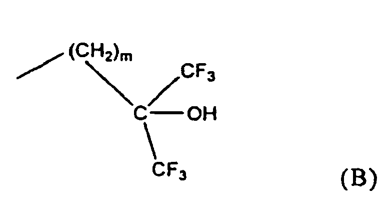 ou 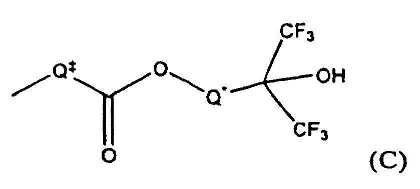 où m est un nombre entier de 1 à 3 inclus et Q^{‡} est tel que défini dans la revendication 2, et Q* est un espaceur alkyle linéaire ou ramifié avec 1 à 5 atomes de carbone.

8. Polymère non auto-imageable selon la revendication 7, comprenant 40 à 98 pour cent molaire du premier type de motif répété et indépendamment, le cas échéant, 1 à 30 pour cent molaire du troisième type de motif répété, et 1 à 40 pour cent molaire du quatrième type de motif répété et du motif répété de la formule (IV), de préférence comprenant 50 à 80 pour cent molaire du premier type de motif répété et indépendamment, le cas échéant, 10 à 25 pour cent molaire du troisième type de motif répété, et 5 à 30 pour cent molaire du quatrième type de motif répété et du motif répété de la formule (IV).

9. Polymère non auto-imageable selon l'une quelconque des revendications 1, 2 ou 7, comprenant en outre un motif répété alkylnorbornène linéaire ou ramifié 5-substitué ou un ester alkylique de norbornène linéaire ou ramifié 5-substitué, de préférence dans lequel ledit motif répété alkylnorbornène linéaire ou ramifié 5-substitué ou ledit motif répété ester alkylique 5-substitué est un motif répété hexyl- ou butylnorbornène 5-substitué ou un ester isobornylique de norbornène 5-substitué.

10. Polymère non auto-imageable selon les revendications 8 ou 9, présentant un poids moléculaire (Mw) compris entre 2000 et 10000, de préférence compris entre 3500 et 7000.

11. Polymère non auto-imageable selon la revendication 2, comprenant 60 à 85 pour cent molaire du premier motif répété, 15 à 40 pour cent molaire du troisième motif répété, et dans laquelle pour chaque motif répété, n est 0, R⁵ est CF₃, R¹⁰ est C₂F₅, Q est CH₂, m est 1, et Q^{‡} n'est pas présent.

12. Polymère non auto-imageable selon la revendication 11, comprenant 75 à 85 pour cent molaire du premier motif répété, 15 à 25 pour cent molaire du troisième motif répété, et présentant un poids moléculaire (Mw) compris entre 3000 et 6000 avec une polydispersité de 2 ou moins.

13. Procédé pour produire un polymère non auto-imageable constitué de motifs répétés de type norbornène, comprenant les étapes consistant à : charger un réacteur avec un premier monomère de type norbornène représenté par la formule IA : 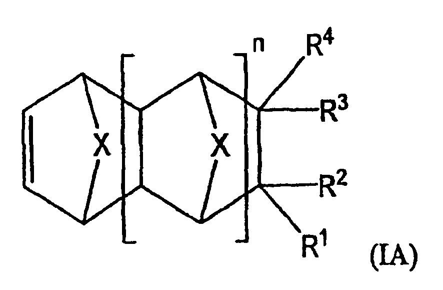 où X est -CH₂-, -CH₂CH₂-, O ou S, n est un nombre entier de 0 à 5 inclus, R¹ à R⁴ représentent chacun indépendamment hydrogène, un groupe alkyle linéaire ou ramifié, ou un groupe haloalkyle linéaire ou ramifié, à condition qu'au moins un parmi R¹ à R⁴ soit un groupe -QNHSO₂R⁵, où Q est un espaceur alkyle linéaire ou ramifié avec 1 à 5 atomes de carbone et R⁵ est un groupe perhalogéné avec 1 à 10 atomes de carbone, et un monomère de type norbornène représenté par la formule IVA : 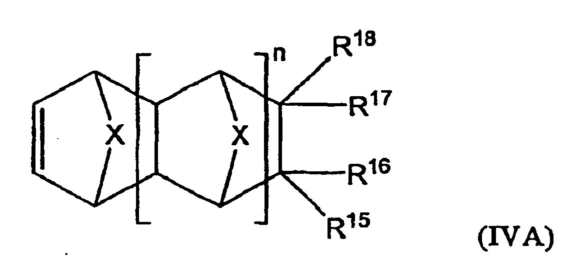 où X et n sont tels que définis pour la formule 1 et R¹⁵ à R¹⁸ représentent chacun indépendamment hydrogène, un groupe alkyle linéaire ou ramifié, ou un groupe haloalkyle linéaire ou ramifié, à condition qu'au moins un parmi R¹⁵ à R¹⁸ soit un des groupes D, E ou F : 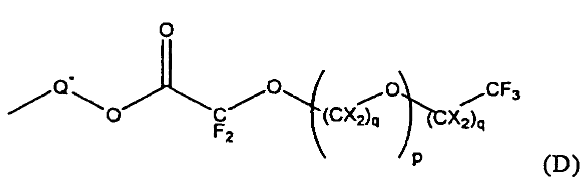 ou 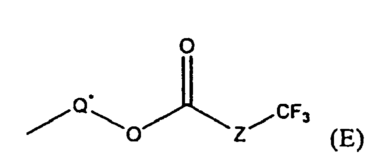 ou 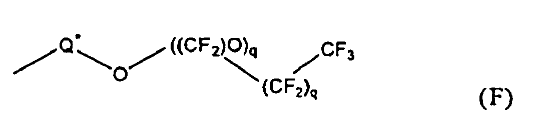 où chaque X est indépendamment soit F soit H, chaque q est indépendamment un nombre entier de 1 à 3, p est un nombre entier de 1 à 5, Q* est un espaceur alkyle linéaire ou ramifié avec 1 à 5 atomes de carbone, et Z est un espaceur halogéné ou perhalogéné, linéaire ou ramifié, avec 2 à 10 atomes de carbone ;
éventuellement charger le réacteur avec un ou plusieurs autres monomères de type norbornène, lesdits autres monomères étant structurellement différents dudit premier monomère ;
charger encore le réacteur avec un solvant approprié, un catalyseur et un cocatalyseur optionnel ;
agiter le contenu du réacteur pour faire le premier monomère, d'autres monomères optionnels, le catalyseur et le cocatalyseur optionnel dissoudre dans le solvant ; et
chauffer et agiter continument le contenu pendant un temps suffisant pour faire polymériser le premier monomère, le monomère de formule IVA et le cas échéant les autres monomères présents là-dedans.

14. Procédé selon la revendication 13, dans lequel l'étape éventuelle de charger le réacteur comprend l'étape consistant à charger le réacteur avec un monomère de type norbornène représenté par la formule IIA : 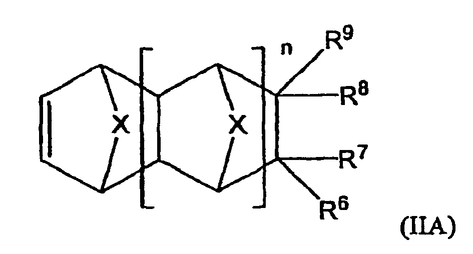 où X et n sont tels que définis pour la formule I, et R⁶ à R⁹ représentent chacun indépendamment hydrogène, un groupe alkyle linéaire ou ramifié, ou un groupe haloalkyle linéaire ou ramifié, à condition qu'au moins un parmi R⁶ à R⁹ soit -Q^{‡}(CO)O-(CH₂)ₘ-R¹⁰, où Q^{‡} est un espaceur alkyle linéaire ou ramifié facultatif avec, le cas échéant, 1 à 5 atomes de carbone,
m est soit 0 soit un nombre entier de 1 à 3 inclus et R¹⁰ est un groupe alkyle perhalogéné linéaire ou ramifié avec 1 à 10 atomes de carbone.

15. Procédé selon la revendication 13, dans lequel l'étape éventuelle de charger le réacteur comprend l'étape consistant à charger le réacteur avec un monomère de type norbornène représenté par la formule IIA et un ou plusieurs monomères de type norbornène représentés par la formule IIIA : 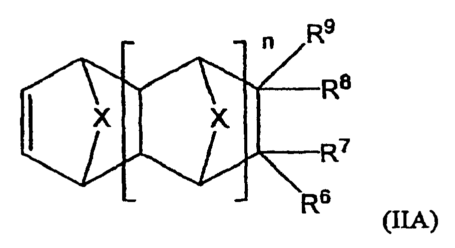 où X et n sont tels que définis pour la formule IA, et R⁶ à R⁹ représentent chacun indépendamment hydrogène, un groupe alkyle linéaire ou ramifié, ou un groupe haloalkyle linéaire ou ramifié, à condition qu'au moins un parmi R⁶ à R⁹ soit -Q^{‡}(CO)O-(CH₂)ₘ-R¹⁰, où Q^{‡} est un espaceur alkyle linéaire ou ramifié facultatif avec, le cas échéant, 1 à 5 atomes de carbone,
m est soit 0 soit un nombre entier de 1 à 3 inclus et R¹⁰ est un groupe alkyle perhalogéné linéaire ou ramifié avec 1 à 10 atomes de carbone ; 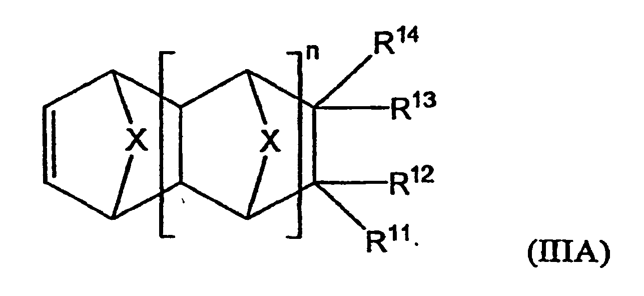 où X et n sont tels que définis pour la formule IA et R¹¹ à R¹⁴ représentent chacun indépendamment hydrogène, un groupe alkyle linéaire ou ramifié, ou un groupe haloalkyle linéaire ou ramifié, à condition qu'au moins un parmi R¹¹ à R¹⁴ soit un des groupes A, B ou C : 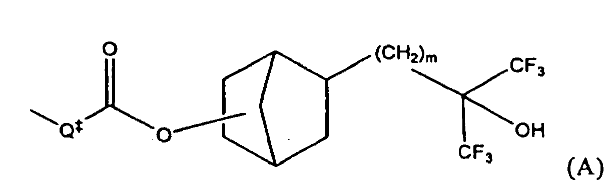 ou 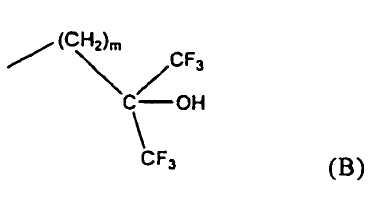 ou 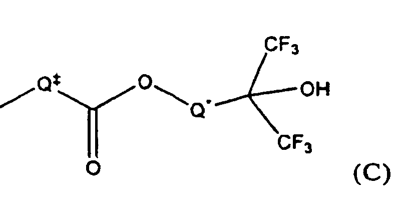 où m est un nombre entier de 1 à 3 inclus et Q^{‡} est tel que défini dans la revendication 2, et Q* est un espaceur alkyle linéaire ou ramifié avec 1 à 5 atomes de carbone.

16. Procédé selon la revendication 15, dans lequel les monomères de type norbornène représentés par la formule IIIA éventuellement chargés comprennent en outre des monomères de type alkylnorbornène linéaire ou ramifié 5-substitué et des monomères de type ester alkylique de norbornène linéaire ou ramifié 5-substitué.

17. Procédé selon l'une quelconque des revendications 13, 14, 15 ou 16, dans lequel l'étape de charger encore le réacteur comprend l'étape consistant à charger le réacteur avec :
un solvant choisi dans le groupe consistant en benzène, toluène, xylène, hexane, heptane, cyclohexane, dichlorométhane, chlorure d'éthyle, tétrahydrofuranne, acétate d'éthyle et des mélanges de ceux-ci ;
un cocatalyseur optionnel choisi parmi l'éthérate diéthylique du tétrakis(pentafluorophényl)borate de lithium (LiFABA) et le tétrakis(pentafluorophényl)borate de N-diméthylanilinium (DANFABA) ; et
un catalyseur choisi parmi le tétrakis(pentafluorophényl)borate d'(acétonitrile)bis(triisopropylphosphine)palladium(acétate) (Pd 1206) et le tétrakis(pentafluorophényl)borate d'(acétonitrile)bis(tricyclohexyl-t-butylphosphine)palladium(acétate) (Pd 1394).

18. Procédé selon la revendication 13, dans lequel l'étape de chauffer comprend l'étape consistant à chauffer le contenu du réacteur à une température choisie dans une gamme de 60 °C à 100 °C et à tenir le contenu à cette température pendant 24 heures ou jusqu'à l'achèvement de la réaction de polymérisation, selon ce qui est le plus rapide.
